(19) Europäisches Patentamt
European Patent Office
Office européen des brevets

(11) EP 2 312 667 A1

(12) EUROPEAN PATENT APPLICATION
published in accordance with Art. 153(4) EPC

(43) Date of publication:
**20.04.2011 Bulletin 2011/16**

(21) Application number: **09803022.4**

(22) Date of filing: **30.07.2009**

(51) Int Cl.:
***H01L 51/50*** *(2006.01)* ***C09K 11/06*** *(2006.01)*
***H05B 33/10*** *(2006.01)*

(86) International application number:
**PCT/JP2009/063588**

(87) International publication number:
**WO 2010/013780 (04.02.2010 Gazette 2010/05)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **31.07.2008 JP 2008198250**

(71) Applicant: **Mitsubishi Chemical Corporation**
**Tokyo 108-0014 (JP)**

(72) Inventors:
- **TAKAHASHI Atsushi**
  **Yokohama-shi**
  **Kanagawa 227-8502 (JP)**
- **OKAMOTO Hideaki**
  **Tokyo 108-0014 (JP)**

(74) Representative: **Vossius & Partner**
**Siebertstrasse 4**
**81675 München (DE)**

# (54) COMPOSITION FOR ORGANIC ELECTROLUMINESCENT ELEMENT, ORGANIC THIN FILM, ORGANIC ELECTROLUMINESCENT ELEMENT, ORGANIC EL DISPLAY DEVICE, AND ORGANIC EL LIGHTING

(57) An organic electroluminescence element comprising a luminescent layer formed by a wet film-forming method, which is a long-life organic electroluminescence element is provided. A composition for an organic electroluminescence element, which comprises: two or more kinds of organic electroluminescence element materials including a luminescent material; and a solvent, wherein the composition satisfies the following formula (I):

[Math. 1]

$$\frac{(\text{Saturated solubility of EL material S})}{(\text{Weight ratio of EL material S})} \times \frac{(\text{Weight ratio of EL material N})}{(\text{Saturated solubility of EL material N})} \geq 2.0 \quad \ldots (1)$$

(wherein the EL material S is an organic electroluminescence element material having a smallest weight in the composition, the EL material N is an organic electroluminescence element material having a largest weight in the composition, the weight ratio is the weight ratio between the EL material S and the EL material N, and the saturated solubility is the saturated solubility of the material at 20˚C and 1 atm for the solvent in the composition).

EP 2 312 667 A1

[ FIG. 1 ]

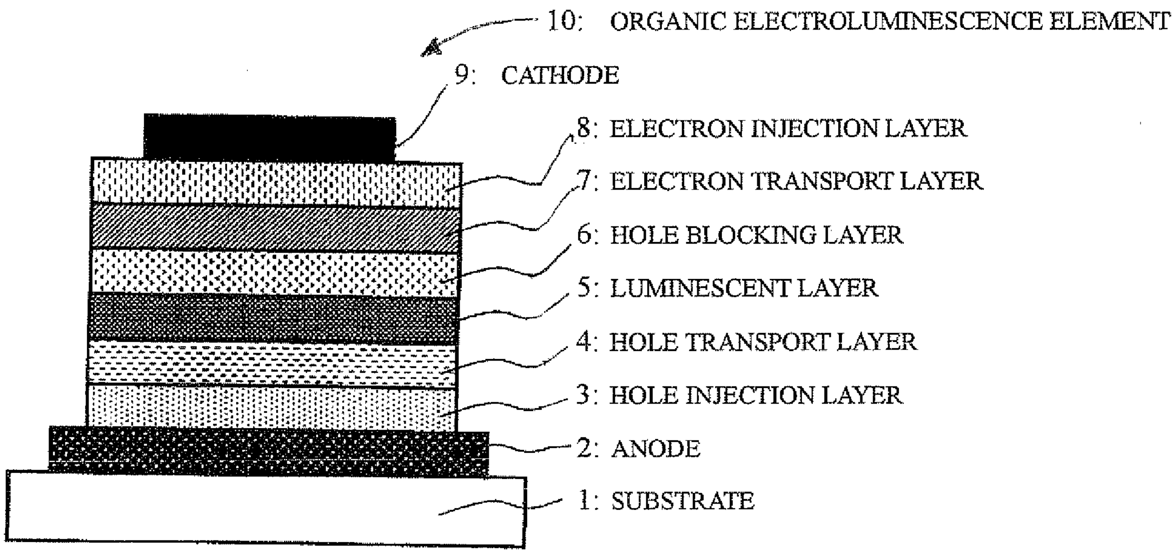
10: ORGANIC ELECTROLUMINESCENCE ELEMENT
9: CATHODE
8: ELECTRON INJECTION LAYER
7: ELECTRON TRANSPORT LAYER
6: HOLE BLOCKING LAYER
5: LUMINESCENT LAYER
4: HOLE TRANSPORT LAYER
3: HOLE INJECTION LAYER
2: ANODE
1: SUBSTRATE

## Description

TECHNICAL FIELD

The present invention relate to a composition for organic electroluminescence (organic EL) elements, which is used for forming a luminescent layer of an organic electroluminescence element by a wet film-forming method.
The present invention also relate to an organic electroluminescence element using the composition for organic electroluminescence elements, and an organic EL display and an organic EL lighting each using the organic electroluminescence element.

BACKGROUND ART

In recent years, an organic electroluminescent (organic EL) element is being aggressively developed as a technique to produce a luminescent device such as display and lighting, and the practical use has begun mainly in small and medium size display applications.
The organic electroluminescence element obtains luminescence by injecting positive and negative charges (carriers) in an organic layer disposed between electrodes and recombining these carriers.
Organic electroluminescence elements currently put into practical use are generally fabricated by heating a compound having a relatively low molecular weight under high vacuum conditions, and thereby depositing vapor on a substrate located above the heated compound. However, this vacuum deposition method does not always allow for homogenous vapor deposition on a large-area substrate and is thus unsuited for the production of large-area organic EL panels in large-screen display devices, a large-area surface emission lighting devices and the like. The vacuum deposition method also has a problem in that use the organic material as a vapor deposition source has low efficiency and the production cost of the organic material is likely to rise.
On the other hand, a production method of an organic EL panel by wet film-forming methods such as a spin coating method, an inkjet method, a dip coating method, various printing methods and the like, have been proposed as a technique for producing large-area organic EL panels.
However, the organic electroluminescence element having a luminescent layer formed by a wet film-forming method is disadvantageous in that the life of the element is short.
In order to solve such a problem, for example, Patent Document 1 focuses on the solubility of a material for a solvent in an ink used for the wet film-forming method, and a material having high solubility has been developed.
However, this technique of Patent Document 1 makes a success of enhancement with respect to the solubility of a material, but the life of the obtained element is still insufficient.

RELATED ART

PATENT DOCUMENT

Patent Document 1: JP-A-2004-224766 (the term "JP-A" as used herein means an "unexamined published Japanese patent application")

SUMMARY OF THE INVENTION

PROBLEMS THAT THE INVENTION IS TO SOLVE

An object of the present invention is to provide an organic electroluminescence element having a luminescent layer formed by a wet film-forming method, which is a long-life organic electroluminescence element.

MEANS FOR SOLVING THE PROBLEMS

The present inventors believed that the failure in enhancing the life of an organic electroluminescence element having a luminescent layer formed by a wet film-forming method would not be merely attributed to low solvent solubility of a material, and intensive studies were made to solve this problem.
As a result, it was found that the cause of such a problem is not merely the solubility of a material but is dependent on respective precipitation rates of a plurality of solid components associated with the drying of the ink after film formation. That is, in the course of drying the ink, a material added in a small amount to the main component forming each layer, such as dopant, precipitates or aggregates earlier than a material used as the main component, making it difficult to form a thin film in a state of solid components being made compatible uniformly, and this is believed to possibly cause

the above-described problem.

Based on this presumption, a number of studies were made, and as a result of these studies, it has been found that in the drying step of a coating film, the precipitation rate of each material could be controlled by using an ink (composition for film formation) satisfying some specific conditions. Also, it has been found that a homogeneous thin film can be formed without causing segregation or aggregation even when a material having a low solubility is used, and as a result, an organic electroluminescence element having a long life can be obtained. The present invention has been accomplished based on these findings. Thus, embodiments of the present invention may include the following:

(1) A composition for an organic electroluminescence element, comprising: two or more kinds of organic electroluminescence element materials; and a solvent, wherein
at least one of said organic electroluminescence element materials is a fluorescence-emitting material and the composition satisfies the following formula (1) (hereinafter, this composition for organic electroluminescence element is sometimes referred to as a "composition A for organic electroluminescence element,"):

[Math. 1]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \ldots \quad (1)$$

(wherein:

EL material S: an organic electroluminescence element material having a smallest weight in said composition,
EL material N: an organic electroluminescence element material having a largest weight in said composition,
weight ratio: the value of the material in the weight ratio between the EL material S and the EL material N, and
saturated solubility: the saturated solubility (wt%) of the material at 20˚C and 1 atm for the solvent contained in said composition,
provided that each of the EL material N and the EL material S has a saturated solubility of 1 wt% or more for toluene at 20˚C and 1 atm).

(2) The composition for an organic electroluminescence element as described in (1) above, wherein said fluorescence-emitting material is a compound having a molecular weight of 10,000 or less.
(3) The composition for an organic electroluminescence element as described in (1) or (2) above, wherein said EL material N is a charge transport material and said EL material S is a fluorescence-emitting material.
(4) A composition for an organic electroluminescence element, comprising: two or more kinds of organic electroluminescence element materials; and a solvent, wherein the boiling point of said solvent is 150˚C or more,
at least one of said organic electroluminescence element materials is a phosphorescence-emitting material, and the composition satisfies the following formula (2) (hereinafter, this composition for organic electroluminescence element is sometimes referred to as a "composition B for organic electro luminescence element").

[Math. 2]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \ldots (2)$$

(wherein:

EL material S: an organic electroluminescence element material having a smallest weight in said composition,
EL material N: an organic electroluminescence element material having a largest weight in said composition,
weight ratio: the value of the material in the weight ratio between the EL material S and the EL material N, and
saturated solubility: the saturated solubility (wt%) of the material at 20°C and 1 atm for the solvent contained in said composition).

(5) The composition for an organic electroluminescence element as described in (4) above, wherein said phosphorescence-emitting material is a compound having a molecular weight of 10,000 or less.
(6) The composition for an organic electroluminescence element as described in (4) or (5) above, wherein said EL material N is a charge transport material and said EL material S is a phosphorescence-emitting material.
(7) A composition for an organic electroluminescence element, comprising: two or more kinds of organic electroluminescence element materials; and a solvent, wherein
at least one of said organic electroluminescence element materials is a luminescent material and the composition satisfies the following formula (3) for cyclohexylbenzene (hereinafter, this composition for organic electroluminescence element is sometimes referred to as a "composition C for organic electroluminescence element,"):

[Math. 3]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \ldots (3)$$

(wherein:

EL material S: an organic electroluminescence element material having a smallest weight in said composition,
EL material N: an organic electroluminescence element material having a largest weight in said composition,
weight ratio: the value of the material in the weight ratio between the EL material S and the EL material N, and
saturated solubility: the saturated solubility (wt%) of the material at 20°C and 1 atm for cyclohexylbenzene).

Another embodiment of the present invention may include an organic thin film formed using the composition for organic electroluminescence element of the present invention.
Still another embodiment of the present invention may include an organic electroluminescence element having a luminescent layer between an anode and a cathode, wherein the luminescent layer is a layer formed using the composition for organic electroluminescence element of the present invention.

Yet still another embodiment of the present invention may include an organic EL display and an organic EL lighting, each comprising the above-described organic electroluminescence element.

## ADVANTAGE OF THE INVENTION

The composition for organic electroluminescence elements of the present invention ensure that a subsidiary component material(s) blended in a small amount with a main component are prevented from precipitating or aggregating earlier than the main component material, so that a thin film dispersed in a uniform state or a pseudo-uniform state which is an almost uniform, can be formed.
According to the composition for organic electroluminescence elements of the present invention, in an organic electroluminescence element having an organic layer such as luminescent layer formed by a wet film-forming method, the film-formed organic layer may be uniform and excellent in the film quality, so that an organic electroluminescence element having a long life and requiring a low drive voltage may be provided. By using such an organic electroluminescence element, a high-quality organic EL display and a high-quality organic EL lighting may be provided.

## BRIEF DESCRIPTION OF THE DRAWINGS

[Fig. 1] A schematic cross-sectional view showing an example of the organic electroluminescence element of the present invention.

## MODE FOR CARRYING OUT THE INVENTION

A mode for carrying out the present invention is described in detail below, but the following description of the constituent elements is an example (a representative example) of an embodiment of the present invention, and the present invention is not limited to these contents as long as scope of the claims is observed.
Incidentally, in the present invention, the phrase "luminescent material" includes a "fluorescence-emitting material" and a "phosphorescence-emitting material, and when simply referred to as a "luminescent material", this can include both a "fluorescence-emitting material" and a "phosphorescence-emitting material".
Also, as used herein the term "composition for organic electroluminescence elements of the present invention" is a generic term including a "composition A for organic electroluminescence elements of the present invention", a "composition B for organic electroluminescence elements of the present invention" and a "composition C for organic electroluminescence elements of the present invention".
Furthermore, in the composition A for organic electroluminescence elements of the present invention, "toluene" is used as the solvent to show the solubility of the EL material N, the EL material S, the luminescent material and the charge transport material, but "toluene" is a general-purpose solvent in this technical field and is merely selected as an indicator for showing the solubility of the organic electroluminescence element material according to the present invention, and the solvent contained in the composition for organic electroluminescence elements according to the present invention is not limited to toluene.

### [Composition for Organic Electroluminescence elements]

The composition A for organic electroluminescence elements of the present invention is a composition for organic electroluminescence elements, containing two or more kinds of organic electroluminescence element materials and a solvent, wherein at least one of the organic electroluminescence element materials is a fluorescence-emitting material and the composition satisfies the following formula (1):
[Math. 4]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \cdots \ (1)$$

(wherein:

EL material S: an organic electroluminescence element material having a smallest weight in the composition,
EL material N: an organic electroluminescence element material having a largest weight in the composition,
weight ratio: the value of the material in the weight ratio between the EL material S and the EL material N, and
saturated solubility: the saturated solubility (wt%) of the material at 20°C and 1 atm for the solvent contained in the composition,
provided that each of the EL material N and the EL material S has a saturated solubility of 1 wt% or more for toluene at 20°C and 1 atm).

The composition B for organic electroluminescence elements of the present invention is a composition for organic electroluminescence elements, containing two or more kinds of organic electroluminescence element materials and a solvent, wherein the boiling point of the solvent is 150°C or more, at least one of the organic electroluminescence element materials is a phosphorescence-emitting material and the composition satisfies the following formula (2):

[Math. 5]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \cdots (2)$$

(wherein:

EL material S: an organic electroluminescence element material having a smallest weight in the composition,
EL material N: an organic electroluminescence element material having a largest weight in the composition,
weight ratio: the value of the material in the weight ratio between the EL material S and the EL material N, and
saturated solubility: the saturated solubility (wt%) of the material at 20°C and 1 atm for the solvent contained in the composition).
The composition C for organic electroluminescence elements of the present invention is a composition for organic electroluminescence elements, containing two or more kinds of organic electroluminescence element materials and a solvent, wherein at least one of the organic electroluminescence element materials is a luminescent material and the composition satisfies the following formula (3) for cyclohexylbenzene:

[Math. 6]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \cdots (3)$$

(wherein:

EL material S: an organic electroluminescence element material having a smallest weight in the composition,
EL material N: an organic electroluminescence element material having a largest weight in the composition,

weight ratio: the value of the material in the weight ratio between the EL material S and the EL material N, and
saturated solubility: the saturated solubility (wt%) of the material at 20˚C and 1 atm for cyclohexylbenzene).
In the following, the value calculated in the left-hand side of formulae (1) to (3) is sometimes referred to as a "parameter value of the present invention".

[Organic Electroluminescence Element Material]

The organic electroluminescence element material contained in the composition for organic electroluminescence elements of the present invention is described below.

The organic electroluminescence element material for use in the present invention is a material contained in a layer between an anode and a cathode of an organic electroluminescence element. Examples of the organic electroluminescence element material may include a charge transport material having a hole transportability or an electron transportability, a luminescent material, and an electron accepting compound.

The content of the organic electroluminescence element material in the composition for organic electroluminescence elements of the present invention is usually 0.0001 wt% or more, preferably 0.001 wt% or more, more preferably 0.1 wt% or more, and is usually 90 wt% or less, preferably 70 wt% or less, more preferably 50 wt% or less. If the content is less than the lower limit above, the thickness of the coating film becomes thin and when the element is fabricated, a dark spot or a short circuit may be caused. If the content exceeds the upper limit above, the thickness of the coating film becomes thick to bring about a rise in the drive voltage when the element is fabricated, or coating unevenness is liable to occur and this may give rise to luminance unevenness when the element is fabricated.

The organic electroluminescence element material for use in the present invention may have an arbitrary molecular weight as long as the effect of the present invention is not seriously impaired, but the molecular weight is usually 10,000 or less, preferably 5,000 or less, more preferably 4,000 or less, still more preferably 3,000 or less, and is usually 100 or more, preferably 200 or more, more preferably 300 or more, still more preferably 400 or more.
If the molecular weight of the organic electroluminescence element material is too small, the glass transition temperature, melting point, decomposition temperature or the like is likely to become low and the heat resistance of the organic electroluminescence element material and organic thin film is seriously deteriorated, and, for example, the film quality is reduced due to recrystallization, molecular migration or the like, or the impurity concentration is increased in association with thermal decomposition of the material, which sometimes causes deterioration of the element performance.
On the other hand, if the molecular weight is excessively large, the solubility of the organic electroluminescence element material in a solvent may become too low depending on the structure of the organic electroluminescence element material or the kind of the solvent used for the preparation of the composition (ink) and, for example, this sometimes makes the purification in the material production process difficult. Also, there arises a problem that a portion where a thin portion fails to be formed occurs during the film formation or the thickness of the organic thin film formed is too small, and this may give rise to generation of a dark spot or a short circuit when the element is fabricated.

The saturated solubility for toluene at 20˚C and 1 atm of the organic electroluminescence element material contained in the composition A for organic electroluminescence elements of the present invention is usually 1 wt% or more, preferably 2 wt% or more, and is usually 30 wt% or less, preferably 20 wt% or less. When the saturated solubility for toluene as the solubility of the organic electroluminescence element material is in the range above, a uniform film is readily formed and short circuits, defects and the like are rarely generated, so that the element fabricated can have a long drive life.

<Luminescent Material>

At least one of two or more kinds of organic electroluminescence element materials contained in the composition for organic electroluminescence elements of the present invention is a luminescent material, and the composition for organic electroluminescence elements of the present invention is usually used for forming a luminescent layer of an organic electroluminescence element.
The luminescent material is defined as a material having a luminescence quantum yield of 30% or more in a dilute solution at room temperature in an inert gas atmosphere, and satisfying the requirement that from the comparison with a fluorescence or phosphorescence spectrum in a dilute solution, the EL spectrum obtained by energizing the organic electroluminescence element produced using the material partially or entirely attributes to luminescence of the material.
Here, the methods for measuring the luminescence quantum yield of the luminescent material, the fluorescence or phosphorescence spectrum in a solution, and the EL spectrum in an organic electroluminescence element, are as follows.

(Measuring Method of Luminescence Quantum Yield)

The luminescence quantum yield of the luminescent material can be measured using, for example, an absolute

PL quantum yield measurement system, C9920-02 (manufactured by Hamamatsu Photonics K.K.).

Incidentally, for the measurement, a solution obtained by diluting the luminescent material to about 0.01 mmol/L based on the solvent and sufficiently deoxidizing the solution with an inert gas (for example, nitrogen) is used.

(Measuring Method of Fluorescence or Phosphorescence Spectrum in Solution)

The spectrum obtained by irradiating light at an arbitrary wavelength on the same solution as used in the measurement of luminescence quantum efficiency above, to excite the luminescent material, using, for example, a spectrophotometer, F-4500 (manufactured by Hitachi Ltd.), is measured.
The measuring device used is not limited to the above-described measuring device if the same measurement as above can be performed, and other measuring devices may be used.

(Measuring Method of EL Spectrum in Organic Electroluminescence element Fabricated)

The EL spectrum of the organic electroluminescence element can be obtained by dispersing the spectrum. Specifically, a predetermined current is applied to the fabricated element, and the obtained EL spectrum is measured by an instant multiphotometry system, MCPD-2000 (manufactured by Otsuka Electronics Co., Ltd.).

The measuring device used is not limited to the above-described measuring device if the same measurement as above can be performed, and other measuring devices may be used.

The luminescent material is not limited as long as it is usually used as a luminescent material of an organic electroluminescence element. For example, the luminescent material may be a fluorescence-emitting material or a phosphorescence-emitting material. In principle, the fluorescence-emitting material has lower luminous efficiency of the organic electroluminescence element than the phosphorescence-emitting material, but the energy gap in the singlet excited state is smaller than that of a phosphorescence-emitting material at the same emission wavelength. Moreover, the exciton life is very short on the nanosecond order, so that the load imposed on the luminescent material is small and the drive life of the element is likely to become long.

On the other hand, the phosphorescence-emitting material in principle gives very high luminous efficiency of the organic electroluminescence element but the energy gap in the singlet excited state is larger than that of a fluorescent material at the same emission wavelength. Moreover, since the exciton life is long (on the microsecond to millisecond order), the drive life is liable to become long compared with the fluorescence-emitting material. Accordingly, in applications where the luminous efficiency is more important than the life, it is preferred to use a phosphorescence-emitting material. Also, a combination of luminescent materials may be also used, for example, while using a fluorescence-emitting material for blue, a phosphorescence-emitting material may be used for green and red.
With regard to the luminescent material, for the purpose of enhancing the solubility in a solvent, a material in which the molecular symmetry or rigidity is reduced ,or a lipophilic substituent such as alkyl group, is introduced, is preferably used.

Examples of the fluorescence-emitting material out of the luminescent materials are described below, but the fluorescence-emitting material is not limited to these examples.
Examples of the fluorescence-emitting material giving blue luminescence (blue fluorescent dye) include naphthalene, chrysene, perylene, pyrene, anthracene, coumarin, p-bis(2-phenylethenyl)benzene, arylamine and derivatives thereof. Among these, anthracene, chrysene, pyrene, arylamine and derivatives thereof are preferred.
Examples of the fluorescence-emitting material giving green luminescence (green fluorescent dye) include quinacridone, coumarin, an aluminum complex such as $Al(C_9H_6NO)_3$, and derivatives thereof.
Examples of the fluorescence-emitting material giving yellow luminescence (yellow fluorescent dye) include rubrene, perimidone and derivatives thereof.
Examples of the fluorescence-emitting material giving red luminescence (red fluorescent dye) include a DCM (4-(dicyanomethylene)-2-methyl-6-(p-dimethylaminostyryl)-4H-pyran)-based compound, benzopyran, rhodamine, a xanthene such as benzothioxanthene and azabenzothioxanthene, and derivatives thereof.
To speak more specifically about the arylamine derivative that is a derivative giving blue fluorescence, a compound represented by the following formula (X) is preferred as the fluorescence-emitting material in view of luminous efficiency, drive life and the like of the element.

[Chem. 1]

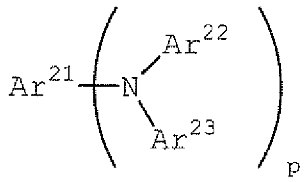

(X)

(wherein $Ar^{21}$ represents a substituted or unsubstituted fused aromatic ring group having a nuclear carbon number of 10 to 40, each of $Ar^{22}$ and $Ar^{23}$ independently represents a substituted or unsubstituted monovalent aromatic group having a carbon number of 6 to 40, and p represents an integer of 1 to 4).
$Ar^{21}$ is specifically a residue structure of naphthalene, phenanthrene, fluoranthene, anthracene, pyrene, perylene, coronene, chrysene, picene, diphenylanthracene, fluorene, triphenylene, rubicene, benzoanthracene, phenylanthracene, bisanthracene, dianthracenylbenzene or dibenzoanthracene.
Specific preferred examples of the arylamine derivative as a fluorescence-emitting material are illustrated below, but the fluorescence-emitting material for use in the present invention is not limited thereto. In the following, "Me" indicates a methyl group, and "Et" indicates an ethyl group.
[Chem. 2]

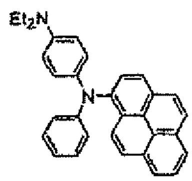
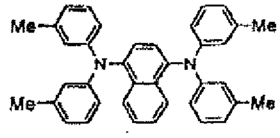

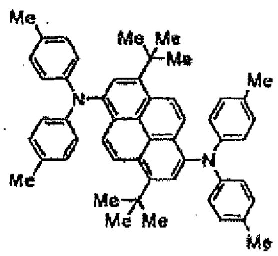
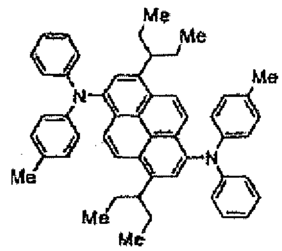
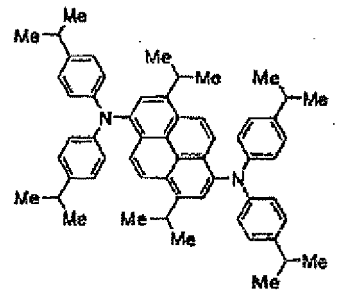

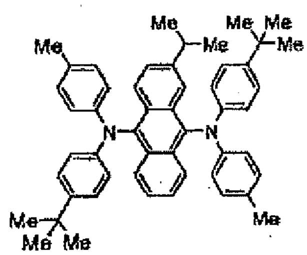
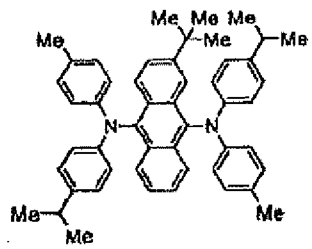
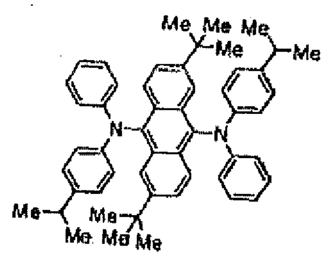

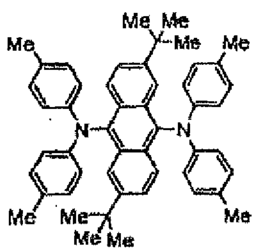
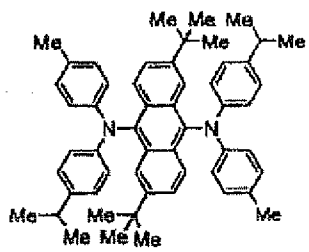
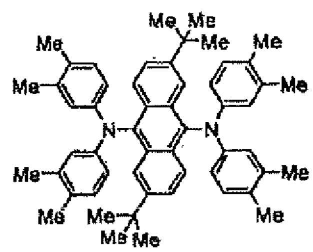

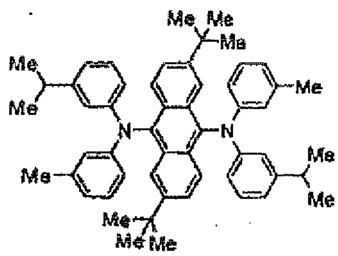
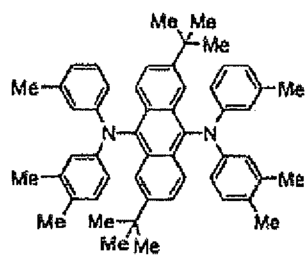

[Chem. 3]

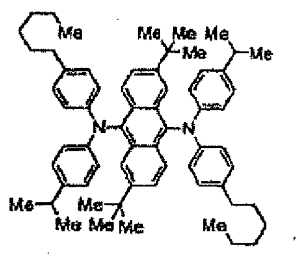
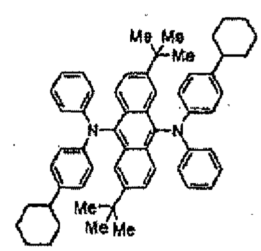
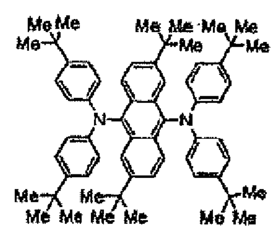

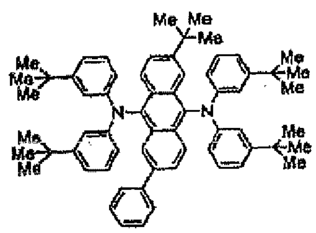
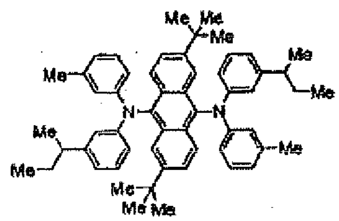

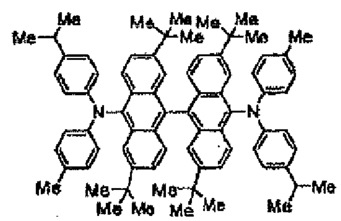
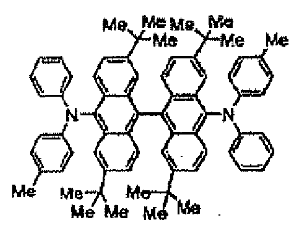

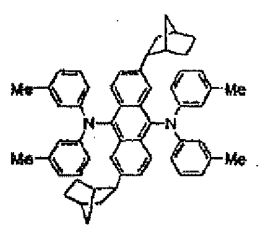
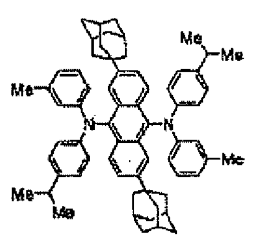
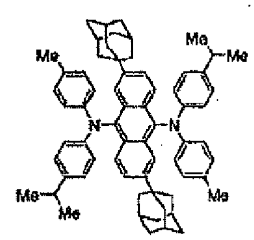

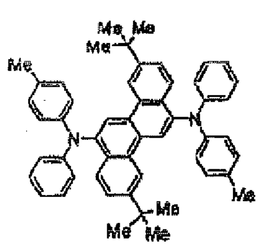
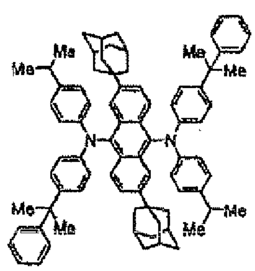

[Chem. 4]

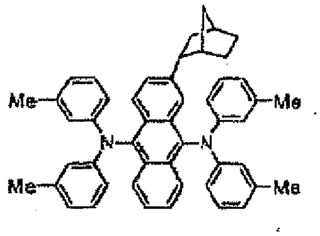
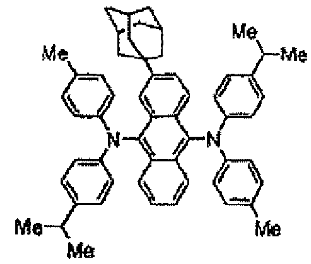
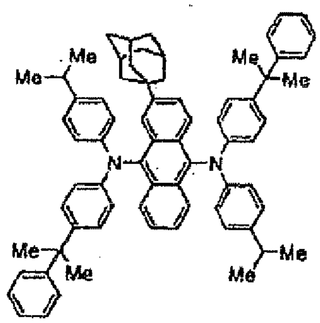
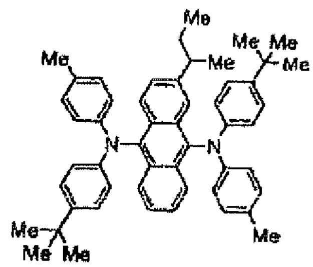
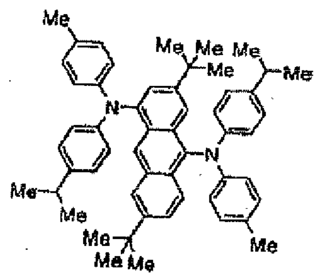
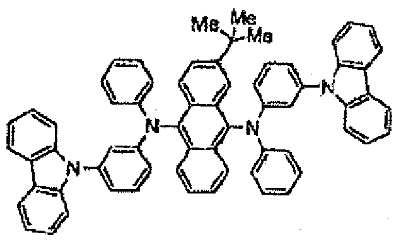
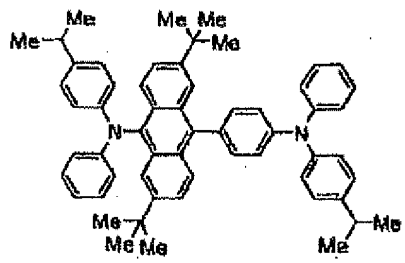
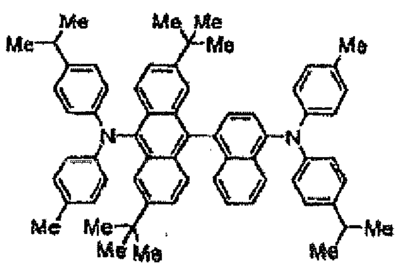
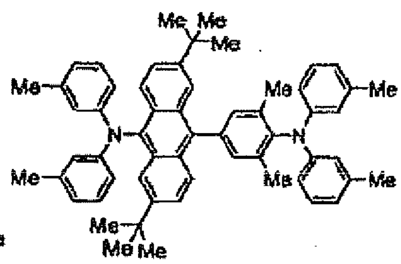
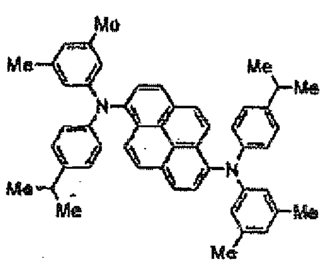
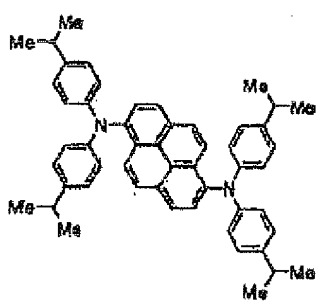
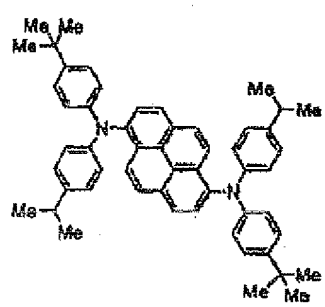

[Chem. 5]

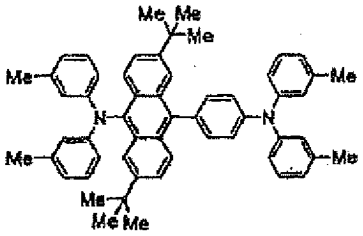
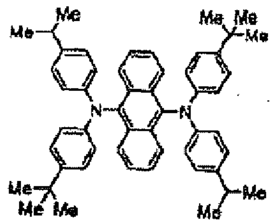
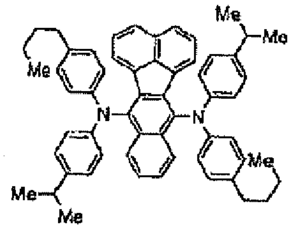

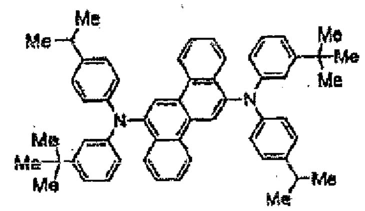
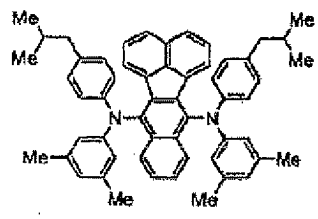

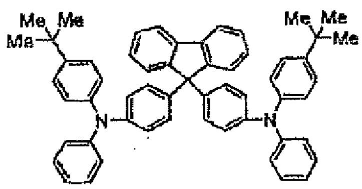
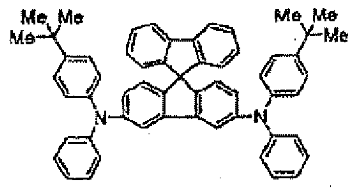

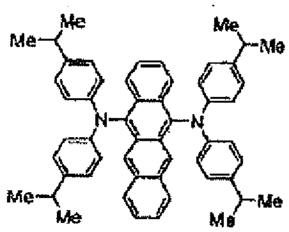
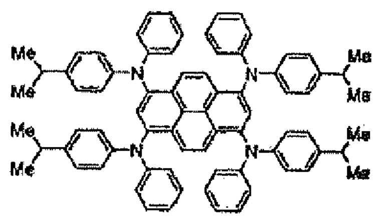

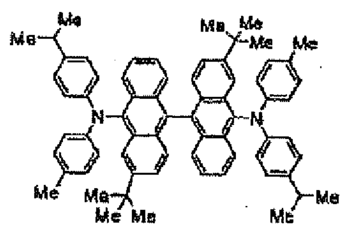

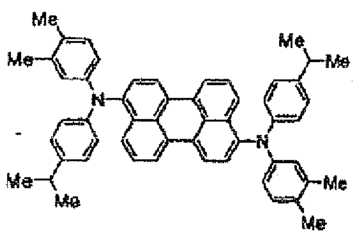
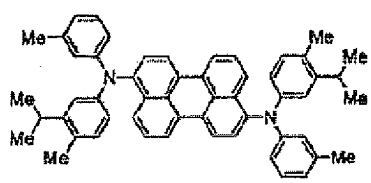

In the present invention, when a fluorescence-emitting material is employed as the luminescent material, it is considered that the effect of the present invention due to satisfying formula (1) can be more effectively obtained for the following reason.

That is, the fluorescence-emitting material easily allows for passing of energy between the same compounds as compared with the phosphorescence-emitting material. Specifically, the film is not homogeneous and when some of the fluorescence-emitting material is present in the vicinity of some more of the same fluorescence-emitting material, the energy released at the return to the ground state from the excited state is not used for luminescence but used for the excitation of the neighboring compound. In other words, due to this repetition, the energy that would be used in luminescence is

instead used for thermal vibration or the like, which affects the current efficiency, drive life or likes of a fabricated element.

With respect to such a fluorescence-emitting material, when the composition satisfies formula (1), it is expected that a homogenization of a film formation state and an enhancement of film quality are obtained, whereby the effect of improving the luminous efficiency or life is more effectively obtained.

On the other hand, examples of the phosphorescence-emitting material include a Werner type complex and an organometallic complex, each containing a metal selected from Groups 7 to 11 of the long period-type periodic table (hereinafter, unless otherwise indicated, the "periodic table" indicates the long period-type periodic table) as the central metal.

Preferred examples of the metal selected from Groups 7 to 11 of the periodic table include ruthenium, rhodium, palladium, silver, rhenium, osmium, iridium, platinum and gold. Among these, iridium and platinum are more preferred.

The ligand of the complex is preferably a ligand where a (hetero)aryl group is coupled with pyridine, pyrazole, phenanthroline or the like, such as (hetero)arylpyridine ligand and (hetero)arylpyrazole ligand. In particular, phenylpyridine ligand and phenylpyrazole ligand are preferred. Here, the (hetero)aryl indicates an aryl group or a heteroaryl group.

Specific examples of the phosphorescence-emitting material include tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, octaethyl platinum porphyrin, octaphenyl platinum porphyrin, octaethyl palladium porphyrin and octaphenyl palladium porphyrin.

In particular, the phosphorescent organic metal complex as a phosphorescence-emitting material is preferably a compound represented by the following formula (III) or (IV):

$$ML_{(q-j)}L'_j \qquad (III)$$

(wherein M represents a metal, q represents the valence of the metal, each of L and L' represents a bidentate ligand, and j represents a number of 0, 1 or 2).

[Chem. 6]

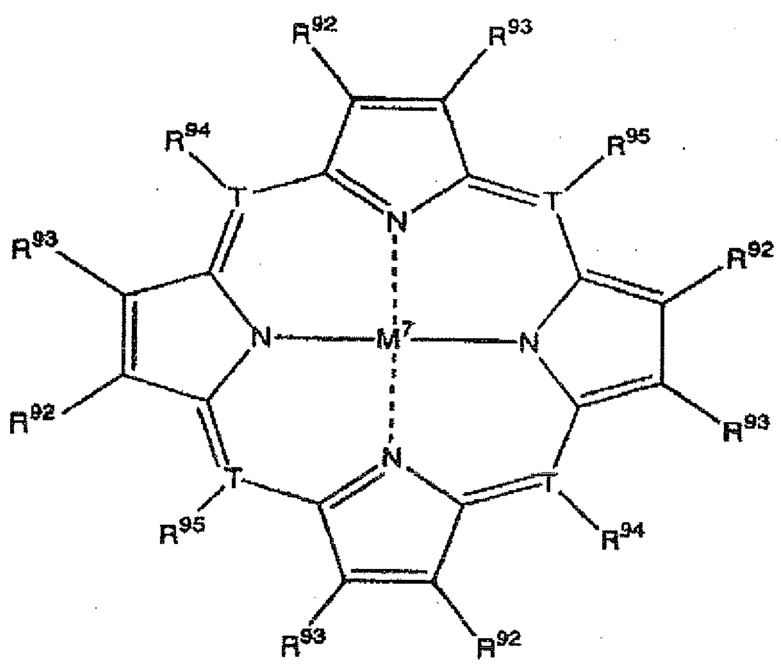

(IV)

(wherein $M^7$ represents a metal, T represents a carbon atom or a nitrogen atom, and each of $R^{92}$ to $R^{95}$ independently represents a substituent, provided that when T is a nitrogen atom, $R^{94}$ and $R^{95}$ are not present).

The compound represented by formula (III) is described below.

In formula (III), M represents an arbitrary metal, and specific preferred examples thereof include the metals described above as the metal selected from Groups 7 to 11 of the periodic table.

Also, in formula (III), the bidentate ligand L indicates a ligand having the following partial structure:

[Chem. 7]

L :

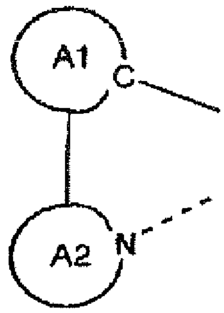

In the partial structure of L above, the ring A1 represents an aromatic hydrocarbon ring or aromatic heterocyclic group, which may have a substituent.
The aromatic hydrocarbon group includes a 5- or 6-membered monocyclic ring and a 2- to 5-condensed ring. Specific examples thereof include a monovalent group derived from a benzene ring, a naphthalene ring, an anthracene ring, a phenanthrene ring, a perylene ring, a tetracene ring, a pyrene ring, a benzopyrene ring, a chrysene ring, a triphenylene ring, an acenaphthene ring, a fluoranthene ring or a fluorene ring.
The aromatic heterocyclic group includes a 5- or 6-membered monocyclic ring and a 2- to 4-condensed ring. Specific examples thereof include a monovalent group derived from a furan ring, a benzofuran ring, a thiophene ring, a benzothiophene ring, a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a thienothiophene ring, a furopyrrole ring, a furofuran ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a cinnoline ring, a quinoxaline ring, a phenanthridine ring, a benzimidazole ring, a perimidine ring, a quinazoline ring, a quinazolinone ring or an azulene ring.

In the partial structure of L above, the ring A2 represents a nitrogen-containing aromatic heterocyclic group which may have a substituent.
The nitrogen-containing aromatic heterocyclic group includes a group derived from a 5- or 6-membered monocyclic ring or a 2- to 4-condensed ring. Specific examples thereof include a monovalent group derived from a pyrrole ring, a pyrazole ring, an imidazole ring, an oxadiazole ring, an indole ring, a carbazole ring, a pyrroloimidazole ring, a pyrrolopyrazole ring, a pyrrolopyrrole ring, a thienopyrrole ring, a furopyrrole ring, a thienofuran ring, a benzisoxazole ring, a benzisothiazole ring, a benzimidazole ring, a pyridine ring, a pyrazine ring, a pyridazine ring, a pyrimidine ring, a triazine ring, a quinoline ring, an isoquinoline ring, a quinoxaline ring, a phenanthridine ring, a benzimidazole ring, a perimidine ring, a quinazoline ring or a quinazolinone ring.

Examples of the substituent which each of the ring A1 and the ring A2 may have, include a halogen atom, an alkyl group, an alkenyl group, an alkoxycarbonyl group, an alkoxy group, an aryloxy group, a dialkylamino group, a diarylamino group, a carbazolyl group, an acyl group, a haloalkyl group, a cyano group and an aromatic hydrocarbon group.
In formula (III), the bidentate L' indicates a ligand having a structural formula shown below. In the following formulae, "Ph" indicates a phenyl group.

[Chem. 8]

L' :

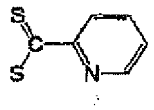 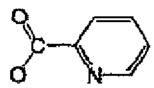 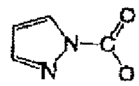 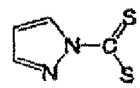 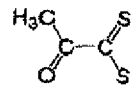 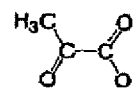

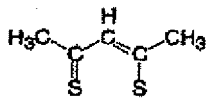 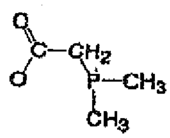 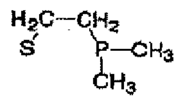 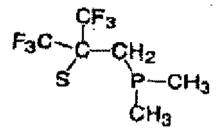 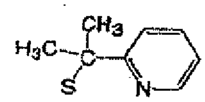

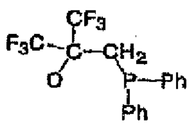 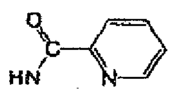 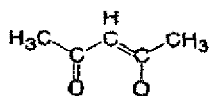 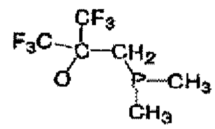 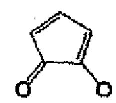

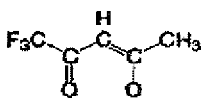 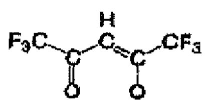 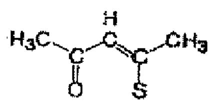 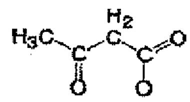

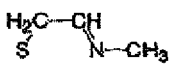 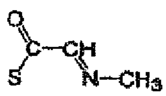 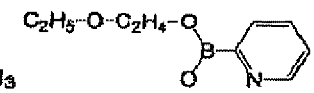 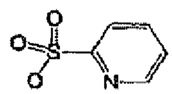 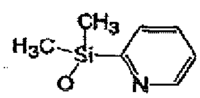

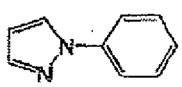 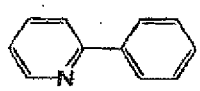 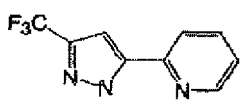 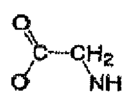

In view of stability of the complex, L' is preferably a ligand shown below.

[Chem. 9]

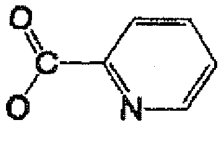
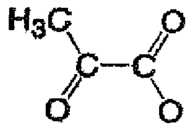
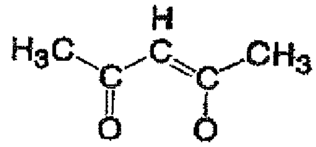

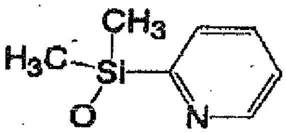
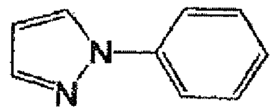
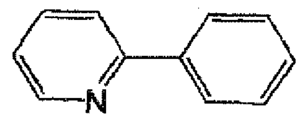

The compound represented by formula (III) is more preferably a compound represented by the following formula (IIIa), (IIIb) or (IIIc):

[Chem. 10]

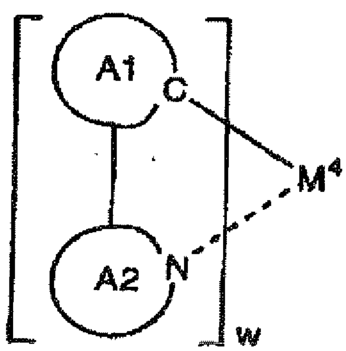

(IIIa)

(wherein $M^4$ represents the same metal as M, w represents the valence of the metal, the ring A1 represents an aromatic hydrocarbon group which may have a substituent, and the ring A2 represents a nitrogen-containing aromatic heterocyclic group which may have a substituent);

[Chem. 11]

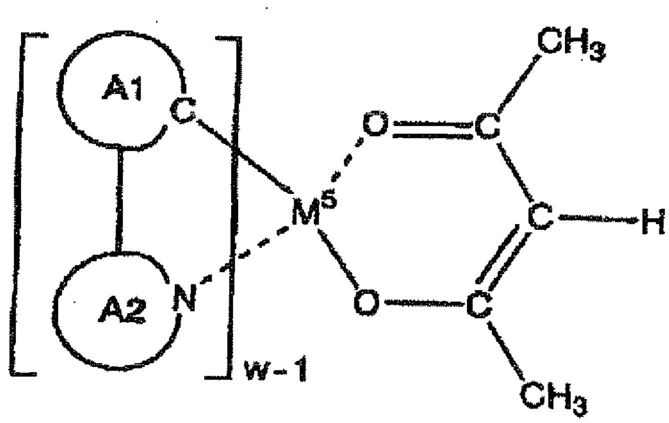

(IIIb)

(wherein $M^5$ represents the same metal as M, w represents the valence of the metal, the ring A1 represents an aromatic hydrocarbon group or aromatic heterocyclic group which may have a substituent, and the ring A2 represents a nitrogen-containing aromatic heterocyclic group which may have a substituent);

[Chem. 12]

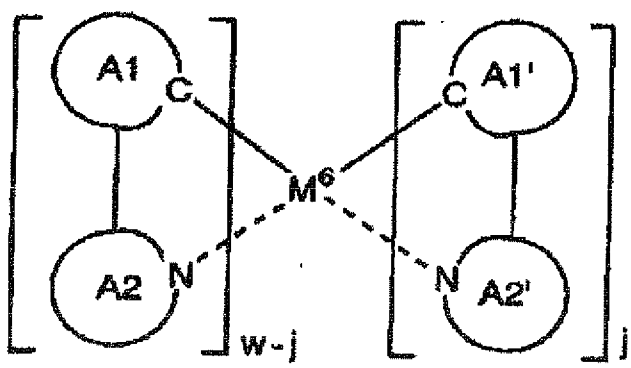

(IIIc)

(wherein $M^6$ represents the same metal as M, w represents the valence of the metal, j represents 0, 1 or 2, each of the ring A1 and the ring A1' independently represents an aromatic hydrocarbon group or aromatic heterocyclic group which may have a substituent, and each of the ring A2 and the ring A2' independently represents a nitrogen-containing aromatic heterocyclic group which may have a substituent).

In formulae (IIIa), (IIIb) and (IIIc), preferred examples of the ring A1 and the ring A1' include a phenyl group, a biphenyl group, a naphthyl group, an anthryl group, a thienyl group, a furyl group, a benzothienyl group, a benzofuryl group, a pyridyl group, a quinolyl group, an isoquinolyl group and a carbazolyl group.

In formulae (IIIa) to (IIIc), preferred examples of the ring A2 and the ring A2' include a pyridyl group, a pyrimidyl group, a pyrazyl group, a triazyl group, a benzothiazole ring, a benzoxazole ring, a benzimidazole ring, a quinolyl ring, an isoquinolyl group, a quinoxalyl group and a phenanthridyl group.

Examples of the substituent, which each of the compounds represented by formulae (IIIa) to (IIIc) may have, include a halogen atom, an alkyl group, an alkenyl group, an alkoxycarbonyl group, an alkoxy group, an aryloxy group, a dialkylamino group, a diarylamino group, a carbazolyl group, an acyl group, a haloalkyl group and a cyano group.

These substituents may combine with each other to form a ring. As a specific example, a substituent on the ring A 1 and a substituent on the ring A2 may combine or a substituent on the ring A1' and a substituent on the ring A2' may combine, to form one condensed ring. Examples of such a condensed ring include a 7,8-benzoquinoline group.

Above all, the substituent on the ring A1, the ring A1', the ring A2 and the ring A2' is more preferably an alkyl group, an alkoxy group, an aromatic hydrocarbon group, a cyano group, a halogen atom, a haloalkyl group, a diarylamino group or a carbazolyl group.

Preferred examples of $M^4$ to $M^6$ in formulae (IIIa) to (IIIc) include ruthenium, rhodium, palladium, silver, rhenium, osmium,

iridium, platinum and gold.

Specific examples of the organometallic complexes represented by formulae (III) and (IIIa) to (IIIc) are illustrated below, but the present invention is not limited to these compounds.

[Chem. 13]

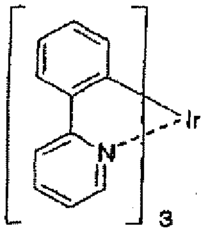
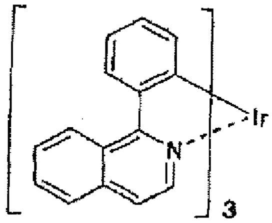
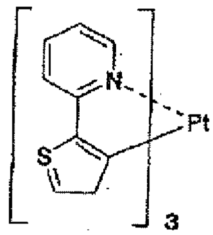

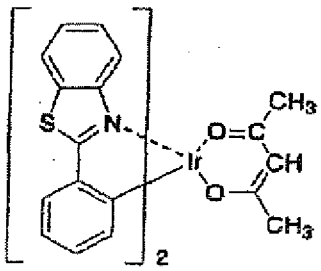
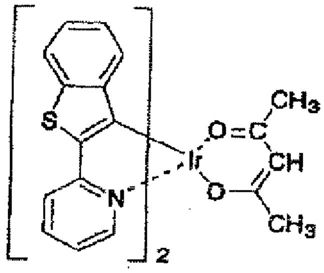
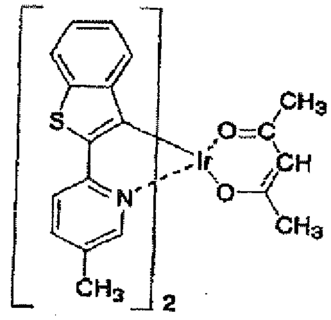

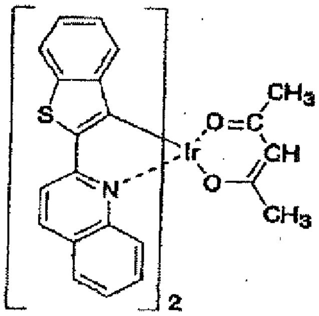
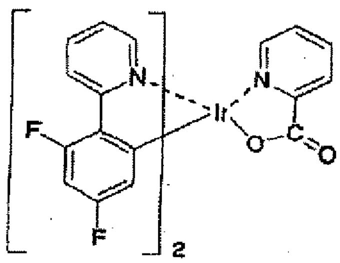

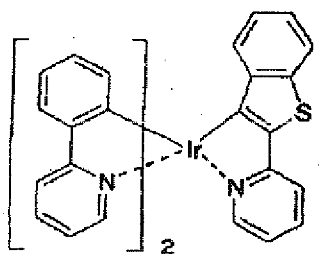
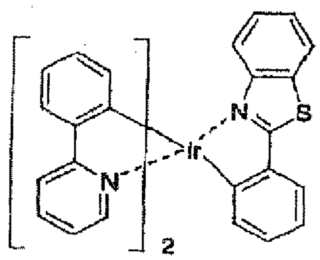
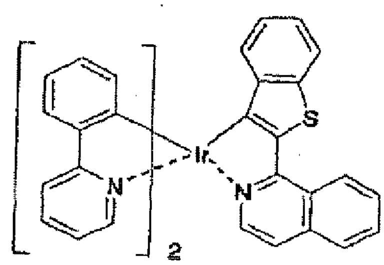

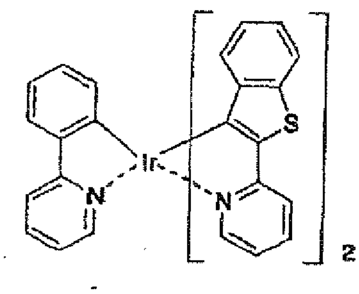
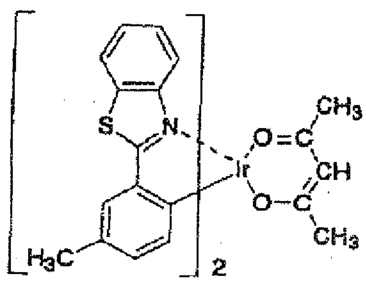
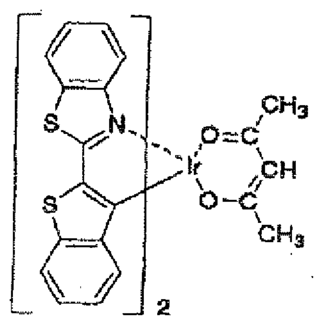

[Chem. 14]

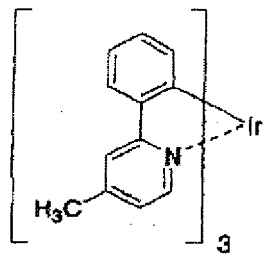
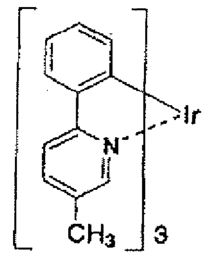
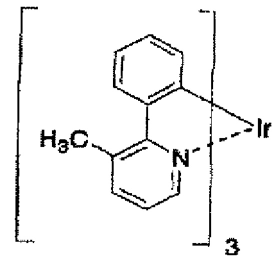

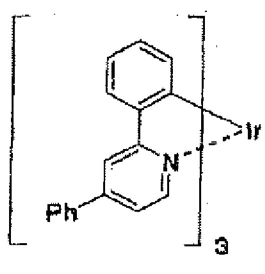
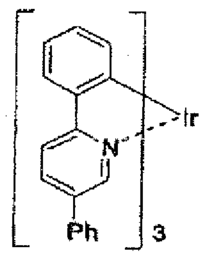
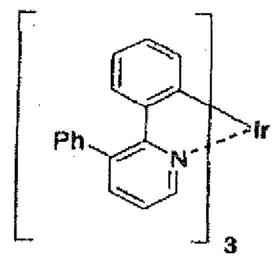

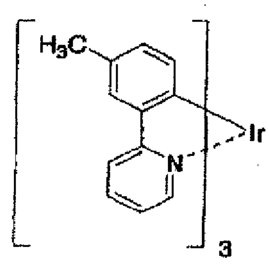
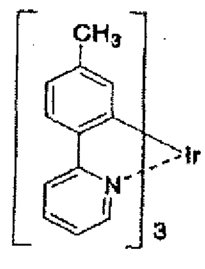
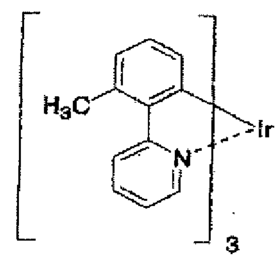

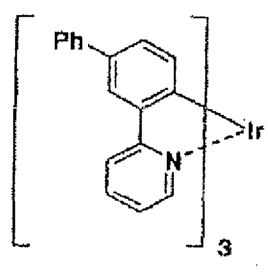
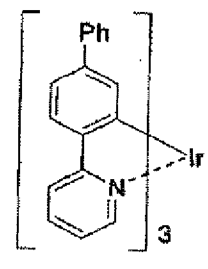
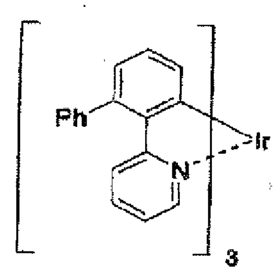

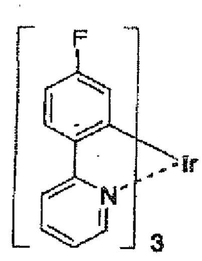
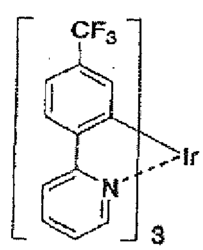
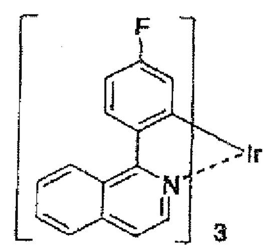

Among the organometallic complexes represented by formula (III), compounds having, as the ligand L and/or L', a 2-arylpyridine-based ligand, that is, a 2-arylpyridine, or a ligand formed by bonding an arbitrary substituent or fusing an arbitrary group to the ligand above are preferred.
In addition, the compounds described in International Publication No. 2005/019373, pamphlet, may also be used as the luminescent material.

The compound represented by formula (IV) is described below.

In formula (IV), $M^7$ represent a metal. Specific examples thereof include the metals described above as the metal selected from Groups 7 to 11 of the periodic table. Among these, ruthenium, rhodium, palladium, silver, rhenium, osmium, iridium, platinum and gold are preferred, and a divalent metal such as platinum and palladium is more preferred.

In formula (IV), each of $R^{92}$ and $R^{93}$ independently represents a hydrogen atom, a halogen atom, an alkyl group, an aralkyl group, an alkenyl group, a cyano group, an amino group, an acyl group, an alkoxycarbonyl group, a carboxyl group, an alkoxy group, an alkylamino group, an aralkylamine group, a haloalkyl group, a hydroxyl group, an aryloxy group, an aromatic hydrocarbon group or an aromatic heterocyclic group.

In the case where T is a carbon atom, each of $R^{94}$ and $R^{95}$ independently represents a substituent whose examples are the same as those for $R^{92}$ and $R^{93}$. Also, when T is a nitrogen atom, $R^{94}$ and $R^{95}$ are not present.

Each of $R^{92}$ to $R^{95}$ may further have a substituent. In the case of having a substituent, the kind of the substituent is not particularly limited, and an arbitrary group may be used as the substituent.

Two or more members out of $R^{92}$ to $R^{95}$ may combine with each other to form a ring.

Specific examples (T-1, T-10 to T-15) of the organometallic complex represented by formula (IV) are illustrated below, but the present invention is not limited to these examples. In the following chemical formula, "Me" indicates a methyl group, and Et indicates an ethyl group.

[Chem. 15]

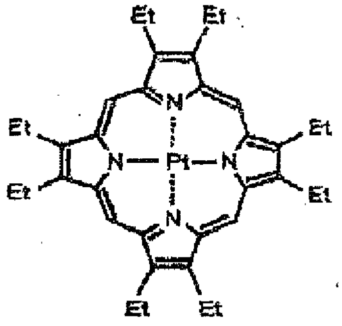

(T-1)

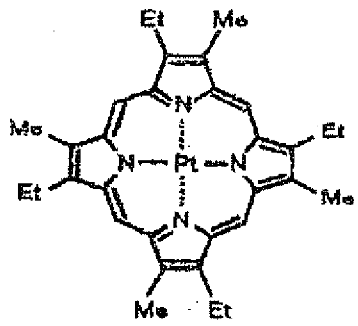

(T-10)

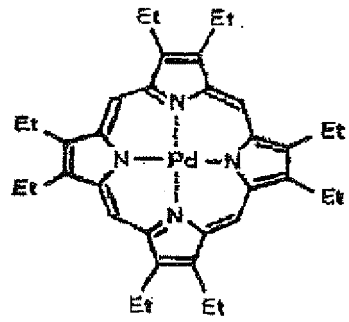

(T-11)

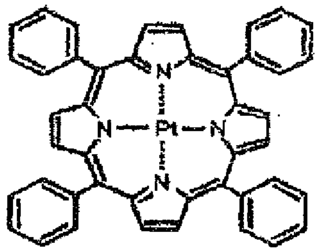

(T-12)

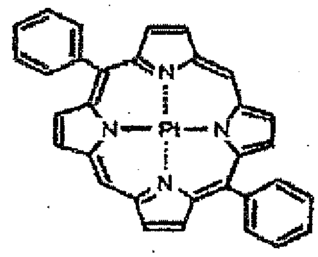

(T-13)

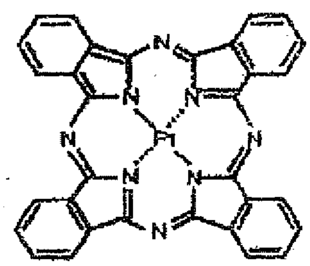

(T-14)

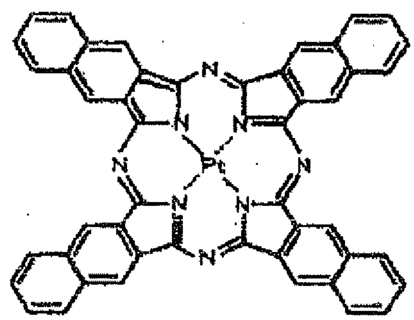

(T-15)

The compound used as the luminescent material may have an arbitrary molecular weight as long as the effect of the present invention is not seriously impaired, but the molecular weight is usually 10,000 or less, preferably 5,000 or less, more preferably 4,000 or less, still more preferably 3,000 or less, and is usually 100 or more, preferably 200 or more, more preferably 300 or more, still more preferably 400 or more. If the molecular weight of the luminescent material is too small, the heat resistance may be seriously impaired, gas generation may occur, the film quality of a film formed may be reduced, or a change in the morphology of the organic electroluminescence element due to migration may be brought about. On the other hand, if the molecular weight of the luminescent material is excessively large, purification of the organic compound may become difficult, or dissolution in a solvent tends to take a long time.

The saturated solubility for toluene at 20˚C and 1 atm of the luminescent material contained in the composition for organic electroluminescence elements of the present invention is usually 1 wt% or more, preferably 2 wt% or more, and is usually 30 wt% or less, preferably 20 wt% or less. When the saturated solubility for toluene as the solubility of the luminescent material is in the range above, a uniform film is readily formed and a short circuit, a defect and the like are scarcely generated, so that the element fabricated can have a long drive life.

Only one of the above-described luminescent materials may be used, or two or more thereof may be used in an arbitrary combination and in an arbitrary ratio.

The content of the luminescent material contained in the composition for organic electroluminescence elements of the

present invention is preferably 0.000001 wt% or more, more preferably 0.0001 wt% or more, still more preferably 0.01 wt% or more, and is preferably 25 wt% or less, more preferably 15 wt% or less, still more preferably 15 wt% or less.

If the content of the luminescent material in the composition for organic electroluminescence elements is less than the lower limit above, there arises a problem in that a portion where a thin film may fail to be formed at the film formation occurs due to insufficient solid content in the composition for organic electroluminescence elements. Alternatively, the thickness of the thin film formed may be too small, and making it impossible to adequately obtain desired functions, which may, for example, give rise to generation of a dark spot or a short circuit of an obtained element. Also, the relative value of the concentration with respect to the charge transport material usually contained in the composition for organic electroluminescence elements is reduced to allow insufficient transfer of an electric charge or an energy from the charge transport material and, for example, the wattage may decrease because of an increase in the reactive current or color deviation may occur due to luminescence from the charge transport material itself.

On the other hand, if the content of the luminescent material in the composition for organic electroluminescence elements exceeds the upper limit discussed above, desired functions may not be adequately obtained. For example, the thickness of the thin film obtained by film formation may become excessively large causing a rise in the drive voltage of the element, or an uneven coating may be generated causing uneven luminance on the luminescent surface of the element. Furthermore, in some cases, additional examples include a quenching phenomenon called concentration quenching is likely to occur due to an increase in the interaction between luminescent material molecules, aggregation of the luminescent material may be caused during drying, or a rise in the drive voltage or a decrease in the element durability tends to result because of the action of the luminescent material as a trap for an electric charge injected into the luminescent layer.

In the case where a plurality of luminescent materials are contained in the composition for organic electroluminescence elements of the present invention, the content indicates the total amount thereof.

<Charge Transport Material>

In the organic electroluminescence element, the luminescent material preferably emits light by receiving an electric charge or energy from a host material having a charge transporting performance. Accordingly, the organic electroluminescence element material contained in the composition for organic electroluminescence elements of the present invention other than the luminescent material is preferably, for example, a charge transport material used as the host material. The charge transport material includes a compound having hole transportability and a compound having electron transportability.

Examples of the charge transport material include an aromatic amine-based compound, a phthalocyanine-based compound, a porphyrin-based compound, a thiophene-based compound, a benzylphenyl-based compound, a fluorene-based compound, a hydrazone-based compound, a silazane-based compound, a silanamine-based compound, a phosphamine-based compound, a quinacridone-based compound, a triphenylene-based compound, a carbazole-based compound, a pyrene-based compound, an anthracene-based compound, a phenanthroline-based compound, a quinoline-based compound, a pyridine-based compound, a triazine-based compound, an oxadiazole-based compound, and an imidazole-based compound.

Specific examples thereof include an aromatic amine-based compound containing two or more tertiary amines, in which two or more fused aromatic rings are substituted on the nitrogen atom, typified by 4,4'-bis[N-(1-naphthyl)-N-phenylamino]biphenyl (JP-A-5-234681); an aromatic amine-based compound having a starburst structure, such as 4,4',4''-tris(1-naphthylphenylamino)triphenylamine (Journal of Luminescence, Vol. 72-74, page 985, 1997); an aromatic amine-based compound composed of a tetramer of triphenylamine (Chemical Communications, page 2175, 1996); a fluorene-based compound such as 2,2',7,7'-tetrakis-(diphenylamino)-9,9'-spirobifluorene (Synthetic Metals, Vol. 91, page 209, 1997); 2,5-bis(1-naphthyl)-1,3,4-oxadiazole (BND); 2,5-bis(6'-(2',2''-bipyridyl))-1,1-dimethyl-3,4-diphenylsilole (PyPySPyPy); bathophenanthroline (BPhen); 2,9-dimethyl-4,7-diphenyl-1,10-phenanthroline (BCP, bathocuproine); 2-(4-biphenylyl)-5-(p-tert-butylphenyl)-1,3,4-oxadiazole (tBu-PBD); and 4,4'-bis(9-carbazole)-biphenyl (CBP).

The charge transport material for use in the present invention may have an arbitrary molecular weight as long as the effect of the present invention is not seriously impaired, but the molecular weight is usually 10,000 or less, preferably 5,000 or less, more preferably 4,000 or less, still more preferably 3,000 or less, and is usually 100 or more, preferably 200 or more, more preferably 300 or more, still more preferably 400 or more.

If the molecular weight of the charge transport material is too small, the glass transition temperature, melting point, decomposition temperature or the like is liable to become low and the heat resistance of the organic electroluminescence element material and the organic thin film obtained is seriously impaired as is the case in the luminescent material, and the film quality is reduced due to recrystallization, molecular migration or the like, or the impurity concentration is increased in association with thermal decomposition of the material, which sometimes causes deterioration of the element performance.

On the other hand, if the molecular weight of the charge transport material is excessively large, the solubility of the

material for a solvent may become too low depending on the structure of the organic electroluminescence element material or the kind of the solvent used for the preparation of the ink and, for example, purification in the material production process becomes difficult. Thus, as a result, the impurity concentration is increased causing a reduction in the luminous efficiency or durability of the organic electroluminescence element; or there arises a problem in that a portion where a thin film may fail to be formed at the coating formation or the thickness of the thin film formed is too small, and this may make it impossible to adequately obtain desired functions, which may, for example, give rise to generation of a dark spot or a short circuit of an obtained element.

The saturated solubility for toluene at 20˚C and 1 atm of the charge transport material contained in the composition for organic electroluminescence elements of the present invention is usually 1 wt% or more, preferably 2 wt% or more, and is usually 30 wt% or less, preferably 20 wt% or less. When the saturated solubility for toluene as the solubility of the charge transport material is in the range above, the composition for organic electroluminescence elements can have good storage stability.

Only one of the above-described charge transport materials may be used, or two or more thereof may be used in an arbitrary combination and in an arbitrary ratio.

The content of the charge transport material contained in the composition for organic electroluminescence elements of the present invention is preferably 0.000001 wt% or more, more preferably 0.0001 wt% or more, still more preferably 0.01 wt% or more, and is preferably 50 wt% or less, more preferably 30 wt% or less, still more preferably 15 wt% or less. It is not preferred that if the content of the charge transport material in the composition for organic electroluminescence elements is less than the lower limit above, because the charge transporting ability of the thin film is decreased and this may cause a rise in the drive voltage or a decrease in the luminous efficiency. In addition, there arises a problem in that a portion where a thin film may fail to be formedat the coating and film formation occurs due to insufficient solid content in the composition for organic electroluminescence elements, or the thickness of the thin film formed is too small, and this may make it impossible to adequately obtain desired functions, which , for example, may give rise to generation of a dark spot or a short circuit of an obtained element, On the other hand, it is not preferred that the content exceeds the upper limit discussed above, because desired functions may not be adequately obtained. For example, the thickness of the thin film obtained by film formation may become excessively large causing a rise in the drive voltage of the element, or coating unevenness is readily generated causing uneven luminance on the luminescent surface of the element.

Also, the ratio of the content of the luminescent material to the content of the charge transport material in the composition for organic electroluminescence elements is preferably 0.01 wt% or more, more preferably 0.1 wt% or more, still more preferably 1 wt% or more, and is preferably 50 wt% or less, more preferably 30 wt% or less, still more preferably 10 wt% or less. If the ratio of the content of the luminescent material to the content of the charge transport material in the composition for organic electroluminescence elements is less than the lower limit above, insufficient transfer of an electric charge or energy from the charge transport material results and, for example, the wattage may decrease because of an increase in the reactive current or color deviation may occur due to luminescence from the charge transport material itself. On the other hand, if this ratio exceeds the upper limit discussed above, for example, a quenching phenomenon generally called concentration quenching may occur due to increase in the interaction between luminescent material molecules, the luminescent material may readily aggregate during drying, or a rise in the drive voltage or a reduction in the element durability may results because of the action of the luminescent material as a trap for an electric charge injected into the luminescent layer.

Also in the case of containing two or more kinds of charge transport materials in the composition, these are contained in the above-described range.

[Solvent]

The composition for organic electroluminescence elements of the present invention includes a solvent. Here, the solvent for use in the present invention is a compound which is liquid in an atmosphere of 20˚C and 1 atom and can dissolve the luminescent material or charge transport material contained in the composition for organic electroluminescence elements of the present invention.

The solvent is not particularly limited as long as it is water or a polar or apolar solvent generally available on the market, but a substituted or unsubstituted aromatic hydrocarbon-based solvent such as benzene, toluene, xylene, mesitylene, cyclohexylbenzene, chlorobenzene and dichlorobenzene, an aromatic ether-based solvent such as anisole, benzoic acid ester and diphenyl ether, an aromatic ester-based solvent, a chain or cyclic alkane-based solvent such as hexane, heptane and cyclohexane, a carboxylic acid ester-based solvent such as ethyl acetate, a carbonyl-containing solvent such as acetone and cyclohexane, an alcohol, a cyclic ether and the like are preferred, an aromatic hydrocarbon-based solvent is more preferred, and benzene, toluene, mesitylene and cyclohexylbenzene are still more preferred.

In the composition for organic electroluminescence elements of the present invention, one kind of a solvent may be contained, or two or more kinds of solvents may be contained in combination, but it is preferred to contain usually

one or more kinds of solvents, preferably 2 or more kinds of solvents, and usually 10 or less kinds of solvents, preferably 8 or less kinds of solvents, more preferably 6 or less kinds of solvent, in combination.

In the case of using two or more kinds of solvents by mixing them, the mixing ratio is not limited, but the mixing ratio is preferably such that the solvent having a largest value in the mixing ratio accounts for, usually 1 wt% or more in the entire solvent, preferably 5 wt% or more, more preferably 10 wt% or more, and usually 100 wt% or less, preferably 90 wt% or less, more preferably 80 wt% or less, and the solvent having a smallest value in the mixing ratio accounts for, usually 0.0001 wt% or more in the entire solvent, preferably 0.001 wt% or more, more preferably 0.01 wt% or more, and usually 50 wt% or less.

In the composition B for organic electroluminescence elements of the present invention having a phosphorescence-emitting material as the luminescent material, a solvent having a boiling point of 150˚C or more is used as the solvent for the following reasons,.

The phosphorescence-emitting material is susceptible to quenching by an oxygen molecule compared with the fluorescence-emitting material and therefore, when an oxygen molecule is present near the phosphorescence-emitting material in the film formed, the current efficiency or drive life of the element is sometimes reduced.

However, when a film is formed using a composition containing a solvent having a boiling point of 150˚C or more, water or oxygen contained in the film is readily removed by heating during film formation and this makes it easy to suppress the quenching by an oxygen molecule. As a result, the element capable the present inventionhigh current efficiency and long drive life may be obtained.

For the above-described reason of using a solvent having a boiling point of 150˚C or more, the solvent having a boiling point of 150˚C or more for use in the composition B for organic electroluminescence elements of the present invention is preferably a solvent that hardly absorbs moisture or oxygen.

The solvent that hardly absorbs moisture is preferably a solvent other than a polar solvent having a large dielectric constant or dipole moment.

As for the oxygen, the solvent temperature is correlates with the saturated solubility and as the temperature is higher, the amount of dissolved oxygen is smaller. For this reason, the boiling point is preferably higher, and a solvent having a boiling point of 150˚C or more, particularly 160˚C or more, more particularly 180˚C or more, is preferred.

Specific examples of such a solvent include a substituted or unsubstituted aromatic hydrocarbon-based solvent such as mesitylene, cyclohexylbenzene and dichlorobenzene, an aromatic ether-based solvent such as anisole, benzoic acid ester and diphenyl ether, and an aromatic ester-based solvent. Among these, an aromatic hydrocarbon-based solvent is preferred, and mesitylene and cyclohexylbenzene are more preferred.

The content in the composition of the solvent having a boiling point of 150˚C or more contained in the composition B for organic electroluminescence elements of the present invention is usually 30 wt% or more, preferably 60 wt% or more, more preferably 70 wt% or more, and is usually 99.99 wt% or less, preferably 99.9 wt% or less, still more preferably 99 wt% or less. When the content of the solvent having a boiling point of 150˚C or more in the composition B for organic electroluminescence elements is in the range above, water or oxygen contained in the formed film can be successfully removed, a quenching phenomenon hardly occurs, and the element has satisfactory current efficiency and drive life.

Incidentally, the composition B for organic electroluminescence elements may contain a solvent having a boiling point lower than 150˚C together with the solvent having a boiling point of 150˚C or more.

That is, for example, in order to adjust the solubility of the solute in the composition or the film-forming property (film quality or film thickness), a solvent having a boiling point of less than 150˚C can be appropriately used according to the coating method or the like. In this case, appropriate adjustment is carried out such that the boiling point of the mixed solvent prepared becomes the boiling point suited for the coating method. For example, in the case of coating by an inkjet method, the solvent having a boiling point of less than 150˚C can be used in combination so as to give a mixed solvent having a boiling point of 180˚C or more, preferably 200˚C or more.

The solvent having a boiling point of less than 150˚C, which can be contained in the composition B for organic electroluminescence elements is not particularly limited as long as it is a solvent that hardly absorbs moisture or oxygen. Specific preferred examples thereof include a substituted or unsubstituted aromatic hydrocarbon-based solvent such as benzene, toluene, xylene and chlorobenzene, a chain or cyclic alkane-based solvent such as hexane, heptane and cyclohexane, a carboxylic acid ester-based solvent such as ethyl acetate, a carbonyl-containing solvent such as acetone and methyl ethyl ketone, an alcohol, and a cyclic ether. Among these, benzene, toluene and xylene are preferred.

In the case where the composition B for organic electroluminescence elements contains a solvent having a boiling point of less than 150˚C together with the solvent having a boiling point of 150˚C or more, as long as the content of the solvent having a boiling point of 150˚C or more in the composition B for organic electroluminescence elements satisfies the above-described preferred range and the boiling point of the mixed solvent is suited for the coating method, the solvent having a boiling point of less than 150˚C can be contained in an arbitrary ratio.

The ratio of the solvent having a boiling point of less than 150˚C to all solvents contained in the composition B for organic electroluminescence elements of the present invention (weight of the solvent having a boiling point of less than 150˚C in the composition/weight of all solvents in the composition) is usually 90% or less, preferably 70% or less,

more preferably 50% or less.

The composition C for organic electroluminescence elements of the present invention contains the above-described solvent. The solvent preferably contains cyclohexylbenzene.

Cyclohexylbenzene is a solvent containing a rigid benzene ring and a flexible cycloalkane in the same molecule and therefore, can dissolve both an organic electroluminescence element material having high solubility for a benzene-based solvent such as toluene and xylene and an organic electroluminescence element material having high solubility for a cycloalkane-based solvent such as cyclohexane and cyclohexanone, in a more balanced manner. Also, because of an apolar hydrocarbon solvent having a high boiling point, hydrogen or moisture is hardly absorbed into the composition and moreover, oxygen or water that is readily introducible into the coating film can be easily removed during drying after coating the composition.

Incidentally, as described above, similar to the composition B for organic electroluminescence elements of the present invention and the composition C for organic electroluminescence elements of the present invention, the composition A for organic electroluminescence elements of the present invention may also contain a solvent having a boiling point of 150°C or more or cyclohexylbenzene as the solvent and also in such a case, the above-described effects of respective solvents contained can be obtained. In this case, the content of each solvent and the content of the solvent used in combination are the same as those described above.

[Other Components]

The composition for organic electroluminescence elements of the present invention may additionally contain a coatability improver such as leveling agent, defoaming agent and thickener, an aid in charge transport, such as electron accepting compound and electron donating compound, a binder resin, and the like. The content of these other components is usually 50 wt% or less from the standpoint of, for example, not seriously inhibiting the charge transfer of the thin film, not inhibiting luminescence of the luminescent material, or not deteriorating the film quality of the thin film.

[Solvent Concentration • Solid Content Concentration]

In the case where the composition for organic electroluminescence elements of the present invention is used as a luminescent layer-forming composition for forming a luminescent layer of the later-described organic electroluminescence element of the present invention, the content of the solvent in the composition for organic electroluminescence elements may be any content as long as the effects of the present invention are not seriously impaired, but the content is usually 30 wt% or more and is usually 99.99 wt% or less. In the case of mixing two or more kinds of solvents and using the mixture as the solvent, the total of these solvents is adjusted to satisfy the range above.

Also, the entire concentration of solid contents in luminescent material, charge transport material and the likes is usually 0.01 wt% or more and is usually 70 wt% or less. If this concentration is excessive large, uneven thickness may be produced, whereas if it is too small, there is a possibility of generating a defect in the film.

{Formulae (1) to (3)}

Formulae (1) to (3) are described below.

[Math. 7]

$$\frac{(\text{Saturated solubility of EL material S})}{(\text{Weight ratio of EL material S})} \times \frac{(\text{Weight ratio of EL material N})}{(\text{Saturated solubility of EL material N})} \geq 2.0 \quad \cdots (1)$$

(wherein:

EL material S: an organic electroluminescence element material having a smallest weight in the composition,
EL material N: an organic electroluminescence element material having a largest weight in the composition,

weight ratio: the value of the material in the weight ratio between the EL material S and the EL material N, and
saturated solubility: the saturated solubility (wt%) of the material at 20˚C and 1 atm for the solvent contained in the composition,
provided that each of the EL material N and the EL material S has a saturated solubility of 1 wt% or more for toluene at 20˚C and 1 atm).

[Math. 8]

$$\frac{(\text{Saturated solubility of EL material S})}{(\text{Weight ratio of EL material S})} \times \frac{(\text{Weight ratio of EL material N})}{(\text{Saturated solubility of EL material N})} \geq 2.0 \quad \ldots (2)$$

(wherein:
EL material S: an organic electroluminescence element material having a smallest weight in the composition,
EL material N: an organic electroluminescence element material having a largest weight in the composition,
weight ratio: the value of the material in the weight ratio between the EL material S and the EL material N, and
saturated solubility: the saturated solubility (wt%) of the material at 20˚C and 1 atm for the solvent contained in the composition).
[Math. 9]

$$\frac{(\text{Saturated solubility of EL material S})}{(\text{Weight ratio of EL material S})} \times \frac{(\text{Weight ratio of EL material N})}{(\text{Saturated solubility of EL material N})} \geq 2.0 \quad \ldots (3)$$

(wherein:

EL material S: an organic electroluminescence element material having a smallest weight in the composition,
EL material N: an organic electro luminescence element material having a largest weight in the composition,
weight ratio: the value of the material in the weight ratio between the EL material S and the EL material N, and
saturated solubility: the saturated solubility (wt%) of the material at 20˚C and 1 atm for cyclohexylbenzene).

In formulae (1) and (2), when two or more kinds of solvents are contained in the composition A or B for organic electroluminescence elements of the present invention, the saturated solubility for the solvent contained in the composition is the saturated solubility for a mixed solvent composed of those two or more kinds of solvents.
In formulae (1) to (3), the saturated solubility of the EL material N is usually 0.01 wt% or more, preferably 1 wt% or more, more preferably 5 wt% or more, and is usually 90 wt% or less, preferably 70 wt% or less, more preferably 50 wt% or less.
The saturated solubility of the EL material S is usually 0.001 wt% or more, preferably 0.01 wt% or more, more preferably 0.1 wt% or more, and is usually 90 wt% or less, preferably 70 wt% or less, more preferably 40 wt% or less.
In formulae (1) to (3), when the weight ratio between the EL material S and the EL material N contained in the composition for organic electroluminescence elements of the present invention is expressed by EL material S : EL material N = a:b, the value of the material in the weight ratio between the EL material S and the EL material N is the weight ratio of the

EL material S = a or the weight ratio of the EL material N = b.

The proportion of the EL material N contained in the organic electroluminescence element material is usually I wt% or more, preferably 5 wt% or more, more preferably 10 wt% or more, and is usually 99.999 wt% or less, preferably 99.9 wt% or less, more preferably 99 wt% or less.

Also, the proportion of the EL material S contained in the organic electroluminescence element material is usually 0.0001 wt% or more, preferably 0.001 wt% or more, more preferably 0.01 wt% or more, and is usually 50 wt% or less, preferably 45 wt% or less, more preferably 40 wt% or less.

In the composition for organic electroluminescence elements of the present invention, the EL material N as a component having a largest weight in the organic electroluminescence element material is usually a charge transport material, and the EL material S having a smallest weight is usually a luminescent material.

The parameter value of the present invention calculated in the left-hand side of formula (1) is 2.0 or more, preferably 2.1 or more, more preferably 2.5 or more, still more preferably 3.0 or more, and is preferably 500 or less, more preferably 200 or less, still more preferably 100 or less.

Also, the parameter value of the present invention calculated in the left-hand side of formula (2) is 2.0 or more, preferably 2.5 or more, more preferably 3.0 or more, still more preferably 5.0 or more, and is preferably 500 or less, more preferably 200 or less, still more preferably 100 or less.

Furthermore, the parameter value of the present invention calculated in the left-hand side of formula (3) is 2.0 or more, preferably 2.1 or more, more preferably 2.5 or more, still more preferably 3.0 or more, and is preferably 500 or less.

If this value exceeds the above-described upper limit, the precipitation rate of the EL material N as the organic electroluminescence element material of the largest content becomes too high and in the initial stage of the drying step, concentration unevenness of the EL material S as the organic electroluminescence element material of the smallest content may disadvantageously occur. Conversely, if it is less than the lower limit, the precipitation rate of the EL material S as the organic electroluminescence element material of the smallest content becomes too high and aggregation or segregation may disadvantageously occur.

In the case where two or more kinds of organic electroluminescence element materials corresponding to the EL material N are present in the composition for organic electroluminescence elements, i.e., when two or more kinds of organic electroluminescence element materials that have the same weight amount are contained in the composition for organic electroluminescence elements and the content of each is largest among organic electroluminescence element materials in the composition for organic electroluminescence elements, it is sufficient if the material having a higher saturated solubility for the solvent in the composition among them satisfies formulae (1) to (3), and it is preferred that the two or more kinds of the EL material N each satisfy formulae (1) to (3).

Similarly, in the case where two or more kinds of organic electroluminescence element materials corresponding to the EL material S are present in the composition for organic electroluminescence elements, i.e., when two or more kinds of organic electroluminescence element materials that have the same weight amount are contained in the composition for organic electroluminescence elements and content of each is smallest among organic electroluminescence element materials in the composition for organic electroluminescence elements, it is sufficient if the material having lower saturated solubility for the solvent in the composition among them satisfies formulae (1) to (3), and it is preferred that the two or more kinds of the EL material S each satisfy formulae (1) to (3).

Also, in the case where two or more kinds of luminescent materials are contained in the composition for organic electroluminescence elements of the present invention, the absolute value of the difference in (weight ratio of the luminescent material to the charge transport material contained in a largest proportion in the composition)/(saturated solubility of the luminescent material for the solvent contained in the composition) is usually 0.1 or more and is usually 10 or less, preferably 5 or less, more preferably 3 or less.

In other words, when, for example, the composition for organic electroluminescence elements contains the luminescent material 1 and the luminescent material 2 having the following contents discussed below and the content of the charge transport material contained in a largest proportion in the composition is $W_x$ (wt%), the value calculated by $|(W_1/W_x/S_1) - (W_2W_x/S_2)|$ is usually 0.1 or more and is usually 10 or less, preferably 5 or less, more preferably 3 or less.

Luminescent material 1:

Saturated solubility (20˚C, 1 atm) for the solvent in the composition = $S_1$ (wt%)

$$\text{Content in the composition} = W_1\ (\text{wt\%})$$

Luminescent material 2:

Saturated solubility (20˚C, 1 atm) for the solvent in the composition = $S_2$ (wt%)

$$\text{Content in the composition} = W_2 \text{ (wt\%)}$$

When this value is in the range discussed above, aggregation of the luminescent material caused due to the differences in the precipitation rates among two or more kinds of luminescent materials can be suppressed and the luminous efficiency of the element is improved. Incidentally, the above-described value is preferably smaller and therefore, its lower limit is ideally "0".

Also, in the case where two or more kinds of charge transport materials are contained in the composition for organic electroluminescence elements of the present invention, the absolute value of the difference in (weight ratio of the charge transport material to the luminescent material contained in a smallest proportion in the composition)/(saturated solubility of the charge transport material for the solvent contained in the composition) is usually 10 or less, preferably 5 or less, more preferably 3 or less.

In other words, when, for example, the composition for organic electroluminescence elements contains the following charge transport material 3 and the charge transport material 4 having the content discussed below and the content of the luminescent material contained in a smallest proportion in the composition is Wy (wt%), the value calculated by $|(W_3 \times W_y/S_3) - (W_4 \times W_y/S_4)|$ is usually 500 or less, preferably 100 or less, more preferably 30 or less.

Charge transport material 3:

Saturated solubility (20˚C, 1 atm) for the solvent in the composition = $S_3$ (we%)

$$\text{Content in the composition} = W_3 \text{ (wt\%)}$$

Charge transport material 4:

Saturated solubility (20˚C, 1 atm) for the solvent in the composition = $S_4$ (wt%)

$$\text{Content in the composition} = W_4 \text{ (wt\%)}$$

When this value is not more than the upper limit above, phase separation in the film is caused by difference in the precipitation rate among two or more kinds of charge transport materials rarely occurs and the drive life of the element is improved. Incidentally, the above-described value is preferably smaller and therefore, its lower limit is ideally "0".

The method for preparing the composition for organic electroluminescence elements of the present invention containing a solvent and two or more kinds of organic electroluminescence element materials and satisfying formulae (1) to (3) is not particularly limited, but examples of the method for setting the combination of a charge transport material and a luminescent material constituting the composition for organic electroluminescence elements to contain the charge transport material as the EL material N, contain the luminescent material as the EL material S and satisfy formula (1) include the following method.

(i) First, measuring the saturated solubility for toluene at 20˚C and 1 atom of each of the charge transport material and the luminescent material, and confirming that each saturated solubility is 1 wt% or more.

(ii) Also, measuring the saturated solubility for the solvent used in the preparation of the composition, of the charge transport material and the luminescent material determined in (i), and thereby the solvent is determined.

In this case, the solvent is selected such that, as described above, the saturated solubility of the charge transport material contained in the composition for the solvent is usually 0.001 wt%, preferably 1 wt% or more, more preferably 5 wt% or more and is usually 90 wt% or less, preferably 70 wt% or less, more preferably 50 wt% or less and the saturated solubility of the luminescent material contained in the composition for the solvent is usually 0.001 wt% or more, preferably 0.01 wt% or more, more preferably 0.1 wt% or more and is usually 90 wt% or less, preferably 70 wt% or less, more preferably 40 wt% or less.

(iii) Next, the compositional ratio between the luminescent material and the charge transport material is appropriately adjusted to satisfy formula (1).
The compositions for organic electroluminescence elements of the present invention satisfying formulae (2) and (3) can also be prepared in the same manner as discussed in the procedure above.
An organic thin film formed using such a composition for organic electroluminescence elements of the present invention is usually used for the luminescent layer of an organic electroluminescence element.

[Organic Electroluminescence element]

The organic electroluminescence element of the present invention has a luminescent layer between an anode and a cathode, wherein the luminescent layer is a layer formed using the above-described composition for organic electroluminescence elements of the present invention, preferably, by a wet film-forming method.

Incidentally, the wet film-forming method as used in the present invention indicates a method where a method of film-forming a film by wet system, such as spin coating method, dip coating method, die coating method, bar coating method, blade coating method, roll coating method, spray coating method, capillary coating method, inkjet method, nozzle printing method, screen printing method, gravure printing method and flexographic printing method, is employed as the film-forming method, i.e. coating method, and the resulting coating film is dried to form a film. Among these film-forming methods, a spin coating method, a spray coating method, an inkjet method and a nozzle printing method are preferred. Such methods suit the liquid property characteristic of the composition for organic electroluminescence elements of the present invention used as the coating composition in the wet film-forming method.

The layer configuration of the organic electroluminescence element of the present invention, the general formation method therefor, and the like are described below by referring to Fig. 1.
Fig. 1 is a schematic cross-sectional view showing a structural example of the organic electroluminescence element of the present invention. In Fig. 1, 1 indicates a substrate, 2 indicates an anode, 3 indicates a hole injection layer, 4 indicates a hole transport layer, 5 indicates a luminescent layer, 6 indicates a hole blocking layer, 7 indicates an electron transport layer, 8 indicates an electron injection layer, and 9 indicates a cathode.

[Substrate]

The substrate 1 is a substrate of an organic electroluminescence element, and a quartz or glass plate, a metal plate or foil, a plastic film or sheet, and the like may be used as the substrate. In particular, a glass plate and a transparent plate formed of synthetic resin such as polyester, polymethacrylate, polycarbonate and polysulfone are preferred. In the case of using a synthetic resin substrate, gas barrier properties must be kept in mind. If the gas barrier property of the substrate is too low, the organic electroluminescence element may be deteriorated by outside air passed through the substrate and this is not preferred. Therefore, a method of providing a dense silicon oxide film or the like on at least one surface of the synthetic resin substrate to ensure the gas barrier property is also a preferred method.

[Anode]

The anode 2 has the role of injecting a hole into the layer on the luminescent layer side.
The anode 2 is usually composed of a metal such as aluminum, gold, silver, nickel, palladium and platinum, a metal oxide such as indium and/or tin oxide, a metal halide such as copper iodide, carbon black, or an electrically conductive polymer such as poly(3-methylthiophene), polypyrrole and polyaniline.
Formation of the anode 2 is usually performed by a sputtering method or a vacuum deposition method. In the case of forming the anode 2 by using, for example, a fine metal particle such as silver, a fine particle of copper iodide or the like, carbon black, a fine electrically conductive metal oxide particle or a fine electrically conductive polymer powder, the anode 2 can also be formed by dispersing the fine particle in an appropriate binder resin solution and coating the dispersion on the substrate 1. Furthermore, in the case of an electrically conductive polymer, the anode 2 can also be formed by forming a thin film directly on the substrate 1 through electrolytic polymerization or coating the electrically conductive polymer on the substrate 1 (see, Appl. Phys. Lett., Vol. 60, page 2711, 1992).
The anode 2 usually has a single-layer structure but, if desired, can be formed to have a multilayer structure composed of a plurality of materials.
The thickness of the anode 2 varies depending on the required transparency. In the case where transparency is required, the transmittance for visible light is desirably set to 60% or more, preferably 80% or more. In this case, the thickness of the anode 2 is usually 5 nm or more, preferably 10 nm or more, and is usually 1,000 nm or less, preferably 500 nm or less. In the case where the anode can be opaque, the thickness of the anode 2 may be arbitrarily selected, and the anode 2 may be the same as the substrate 1. Also, a different electrically conductive material may be further laminated on the anode 2.

For the purpose of removing impurities attached to the anode 2 and adjusting the ionization potential to improve the hole injection performance, the anode 2 surface is preferably subjected to an ultraviolet (UV)/ozone treatment or an oxygen plasma or argon plasma treatment.

[Hole Injection Layer]

The hole injection layer 3 is a layer for transporting a hole to the luminescent layer 5 from the anode 2 and is usually formed on the anode 2.
The method for forming the hole injection layer 3 according to the present invention may be either a vacuum deposition method or a wet film-forming method and is not particularly limited, but to reduce the dark spot, the hole injection layer 3 is preferably formed by a wet film-forming method.
The film thickness of the hole injection layer 3 is usually 5 nm or more, preferably 10 nm or more, and is usually 1,000 nm or less, preferably 500 nm or less.

<Formation of Hole Injection Layer by Wet film-forming method>

In the case of forming the hole injection layer 3 by a wet film-forming method, usually, the materials constituting the hole injection layer 3 are mixed with an appropriate solvent (solvent for hole injection layer) to prepare a composition for film formation (composition for formation of a hole injection layer), and the composition for formation of a hole injection layer is coated on a layer corresponding to the underlying layer (usually anode) of the hole injection layer 3 by an appropriate method to form a film and then dried, whereby the hole injection layer 3 is formed.

(Hole Transporting Compound)

The composition for formation of a hole injection layer usually contains, as the constituent material of the hole injection layer, a hole transporting compound and a solvent.
The hole transporting compound may be a polymer compound or a low molecular compound as long as it is a compound having hole transportability usually used for the hole injection layer of an organic electroluminescence element.
In view of a charge injection barrier from the anode 2 to the hole injection layer 3, the hole transporting compound is preferably a compound having an ionization potential of 4.5 to 6.0 eV. Examples of the hole transporting compound include an aromatic amine-based compound, a phthalocyanine-based compound, a porphyrin-based compound, an oligothiophene-based compound, a polythiophene-based compound, a benzylphenyl-based compound, a compound having tertiary amines connected through a fluorene group, a hydrazone-based compound, a silazane-based compound, a silanamine-based compound, a phosphamine-based compound, and a quinacridone-based compound.
In regard to the hole transporting compound used as a material of the hole injection layer 3, any one of these compounds may be contained alone, or two or more thereof may be contained. In the case of containing two or more kinds of hole transporting compounds, any combination may be employed, but it is preferred that one kind or two or more kinds of aromatic tertiary amine polymer compounds and one kind or two or more kinds of other hole transporting compounds are used in combination.

Among those compounds, in view of amorphous properties and transmittance of visible light, an aromatic amine compound is preferred, and an aromatic tertiary amine compound is more preferred. The aromatic tertiary amine compound as used herein is a compound having an aromatic tertiary amine structure, and a group derived from an aromatic tertiary amine is also included in the aromatic tertiary amine compound.
The aromatic tertiary amine compound is not particularly limited in its kind, but in view of uniform luminescence due to surface smoothing effect, a polymer compound having a weight average molecular weight of 1,000 to 1,000,000 (a polymerized compound of type where repeating units are connected) is more preferred. Preferred examples of the aromatic tertiary amine polymer compound include a polymer compound having a repeating unit represented by the following formula (I):

[Chem. 16]

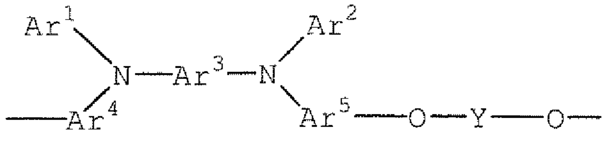

(I)

[wherein each of $Ar^1$ and $Ar^2$ independently represents an aromatic hydrocarbon group which may have a substituent or an aromatic heterocyclic group which may have a substituent, each of $Ar^3$ to $Ar^5$ independently represents an aromatic hydrocarbon group which may have a substituent or an aromatic heterocyclic group which may have a substituent, Y represents a linking group selected from the following group of linking groups, and out of $Ar^1$ to $Ar^5$, two groups bonded to the same N atom may combine with each other to form a ring:

[Chem. 17]

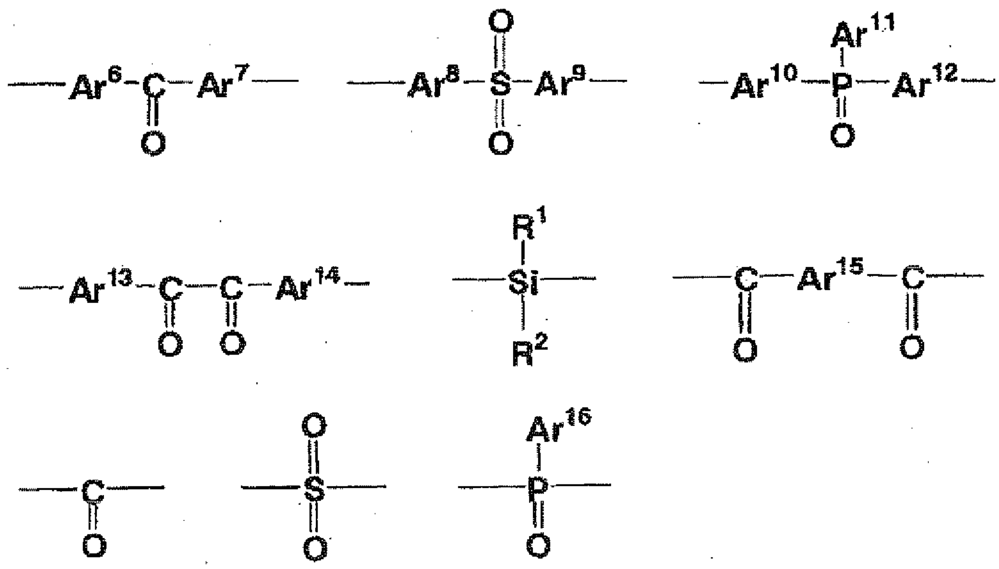

(wherein each of $Ar^6$ to $Ar^{16}$ independently represent an aromatic hydrocarbon group which may have a substituent or an aromatic heterocyclic ring which may have a substituent, and each of $R^1$ and $R^2$ independently represents a hydrogen atom or an arbitrary substituent)].

As for the aromatic hydrocarbon group and aromatic heterocyclic group of $Ar^1$ to $Ar^{16}$, in view of solubility, heat resistance and hole injectability/transportability of the polymer compound, a group derived from a benzene ring, a naphthalene ring, a phenanthrene ring, a thiophene ring or a pyridine ring is preferred, and a group derived from a benzene ring or a naphthalene ring is more preferred.

The aromatic hydrocarbon group and aromatic heterocyclic group of $Ar^1$ to $Ar^{16}$ may further have a substituent. The molecular weight of the substituent is usually 400 or less, preferably about 250 or less. Preferred examples of the substituent include an alkyl group, an alkenyl group, an alkoxy group, an aromatic hydrocarbon group and an aromatic heterocyclic group.

In the case where each of $R^1$ and $R^2$ is an arbitrary substituent, examples of the substituent include an alkyl group, an alkenyl group, an alkoxy group, a silyl group, a siloxy group, an aromatic hydrocarbon group and an aromatic heterocyclic group.

Specific examples of the aromatic tertiary amine polymer compound having a repeating unit represented by formula (I) include the compounds described in International Publication No. 2005/089024, pamphlet.

The concentration of the hole transporting compound in the composition for formation of a hole injection layer may be arbitrarily selected as long as the effects of the present invention are not seriously impaired, but in view of uniformity in the thickness, the concentration is usually 0.01 wt% or more, preferably 0.1 wt% or more, more preferably 0.5 wt% or more, and is usually 70 wt% or less, preferably 60 wt% or less, more preferably 50 wt% or less. If this concentration is excessively large, uneven thickness may occur, whereas if it is too small, a defect may be produced in the formed hole injection layer.

(Electron Accepting Compound)

The composition for formation of a hole injection layer preferably contains an electron accepting compound as the constituent material of the hole injection layer.

The electron accepting compound is preferably a compound having oxidizing power and capability of accepting one

electron from the above-described hole transporting compound. Specifically, a compound having an electron affinity of 4 eV or more is preferred, and a compound having an electron affinity of 5 eV or more is more preferred.
Such an electron accepting compound includes, for example, one kind or two or more kinds of compounds selected from the group consisting of a triarylboron compound, a metal halide, a Lewis acid, an organic acid, an onium salt, a salt of arylamine with metal halide, and a salt of arylamine with Lewis acid. Specific examples thereof include an organic group-substituted onium salt such as 4-isopropyl-4'-methyldiphenyliodonium tetrakis(pentafluorophenyl)borate and triphenylsulfonium tetrafluoroborate (WO2005/089024); iron chloride (only any one kind of iron chloride may be used, or two or more thereof may be used in an arbitrary combination in an arbitrary ratio) (JP-A-11-251067); a high-valence inorganic compound such as ammonium peroxodisulfate; a cyano compound such as tetracyanoethylene; an aromatic boron compound such as tris(pentafluorophenyl)borane (JP-A-2003-31365); a fullerene derivative; and iodine.
Such an electron accepting compound can enhance the electric conductivity of the hole injection layer by oxidizing the hole transporting compound.
The content of the electron accepting compound in the hole injection layer or the composition for formation of a hole injection layer based on the hole transporting compound is usually 0.1 mol% or more, preferably 1 mol% or more, but is usually 140 mol% or less, preferably 40 mol% or less.

(Other Constituent Materials)

With respect to the material of the hole injection layer, in addition to the above-described hole transporting compound and electron accepting compound, other components may be further contained as long as the effects of the present invention are not seriously impaired. Examples of other components include various luminescent materials, electron transporting compounds, binder resins and coatability improvers. Incidentally, only one kind of a component as other components may be used, or two or more kinds of components may be used in an arbitrary combination in an arbitrary ratio, but from the standpoint of ensuring hole injectability from the anode and hole transportability to the cathode side, the content of other components in the hole injection layer is preferably 80 wt% or less.

(Solvent)

Out of the solvents in the composition for formation of a hole injection layer used in a wet film-forming method, at least one solvent is preferably a compound capable of dissolving the above-described constituent materials of the hole injection layer. Also, the boiling point of this solvent is usually 110°C or more, preferably 140°C or more, more preferably 200°C or more, and is usually 400°C or less, preferably 300°C or less. If the boiling point of the solvent is too low, drying proceeds at too high rate and the film quality may deteriorate, whereas if the boiling point of the solvent is excessively high, the temperature in the drying step needs to be raised and this may adversely affect other layers or the substrate.
The solvent may include, for example, an ether-based solvent, an ester-based solvent, an aromatic hydrocarbon-based solvent and an amide-based solvent.
Examples of the ether-based solvent include an aliphatic ether such as ethylene glycol dimethyl ether, ethylene glycol diethyl ether and propylene glycol-1-monomethyl ether acetate (PGMEA); and an aromatic ether such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole.
Examples of the ester-based solvent include an aromatic ester such as phenyl acetate, phenyl propionate, methyl benzoate, ethyl benzoate, propyl benzoate and n-butyl benzoate.
Examples of the aromatic hydrocarbon-based solvent include toluene, xylene, cyclohexylbenzene, 3-isopropylbiphenyl, 1,2,3,4-tetramethylbenzene, 1,4-diisopropylbenzene, cyclohexylbenzene and methylnaphthalene.
Examples of the amide-based solvent include N,N-dimethylformamide and N,N-dimethylacetamide.
In addition, dimethyl sulfoxide and the like may also be used.
Only one of these solvents may be used, or two or more thereof may be used in an arbitrary combination in an arbitrary ratio.

(Film-Forming Method)

After the preparation of the composition for formation of a hole injection layer, the composition is coated by wet film-formation on a layer corresponding to the underlying layer (usually anode 2) of the hole injection layer 3 and dried, whereby the hole injection layer 3 can be formed.
The temperature in the film-forming step is preferably 10°C or more and is preferably 50°C or less so as to prevent the film from being damaged due to production of a crystal in the composition.
The relative humidity in the film-forming step is not limited as long as the effects of the present invention are not seriously impaired, but the relative humidity is usually 0.01 ppm or more and is usually 80% or less.

After the film-forming, the film of the composition for formation of a hole injection layer is usually dried by heating or the like. Examples of the heating device used in the heating step include a clean oven, a hot plate, an infrared ray, a halogen heater, and microwave irradiation. Among these, for evenly applying heat throughout the film, a clean oven and a hot plate are preferred.
As for the heating temperature in the heating step, as long as the effects of the present invention are not seriously impaired, the heating is preferably performed at a temperature not lower than the boiling point of the solvent used in the composition for formation of a hole injection layer. In the case where the solvent used for the hole injection layer is a mixed solvent containing two or more kinds of solvents, the heating is preferably performed at a temperature not lower than the boiling point of at least one kind of the solvent. Considering a rise in the boiling point of the solvent, the heating in the heating step is preferably performed at 120˚C or more and preferably at 410˚C or less.
In the heating step, as long as the heating temperature is not lower than the boiling point of the solvent in the composition for formation of a hole injection layer and full insolubilization of the coating film does not occur, the heating time is not limited but is preferably 10 seconds or more and is usually 180 minutes or less. If the heating time is too long, the components in other layers is liable to diffuse, whereas if it is excessively short, the hole injection layer tends to become non-homogeneous. Heating may be performed in two parts.

<Formation of Hole Injection Layer by Vacuum Deposition Method>

In the case of forming the hole injection layer 3 by a vacuum deposition method, one material or two or more materials out of the constituent materials (for example, the above-described hole transporting compound and electron accepting compound) of the hole injection layer 3 are put in a crucible (when using two or more materials, in respective crucibles) placed in a vacuum vessel, the vacuum vessel is evacuated to about $10^{-4}$ Pa by an appropriate vacuum pump, and then the crucible is heated (in the case of using two or more materials, respective crucibles are heated) to evaporate the material by controlling the amount of evaporation (in the case of using two or more materials, evaporate the materials by independently controlling each amount of evaporation), whereby a hole injection layer 3 is formed on the anode 2 of the substrate placed to face the crucible. Incidentally, in the case of using two or more materials, the hole injection layer 3 may also be formed by putting a mixture of these materials in a crucible, and heating and evaporating the mixture.
The degree of vacuum at the vapor deposition is not limited as long as the effects of the present invention are not seriously impaired, but the degree of vacuum is usually $0.1\times10^{-6}$ Torr ($0.13\times10^{-4}$ Pa) or more and is usually $9.0\times10^{-6}$ Torr ($12.0\times10^{-4}$ Pa) or less. The vapor deposition rate is not limited as long as the effects of the present invention are not seriously impaired, but the vapor deposition rate is usually 0.1 Å/sec or more and is usually 5.0 Å/sec or less. The deposition temperature at the vapor deposition is not limited as long as the effects of the present invention are not seriously impaired, but the vapor deposition is performed preferably at 10˚C or more and preferably at 50˚C or less.

[Hole Transport Layer]

The organic electroluminescence element of the present invention preferably has a hole transport layer 4.
The method for forming the hole transport layer 4 according to the present invention may be either a vacuum deposition method or a wet film-forming method and is not particularly limited, but from the standpoint of reducing the dark spot, the hole transport layer 4 is preferably formed by a wet film-forming method.
In particular, the organic electroluminescence element of the present invention having a luminescent layer formed using the composition for organic electroluminescence elements of the present invention preferably has a hole transport layer from the standpoint of, for example, relieving the hole injection barrier between the hole injection layer and the luminescent layer, preventing reduction in the drive voltage and deterioration of the material due to accumulation of holes on the layer interface, or enhancing the luminous efficiency by increasing the hole injection efficiency into the luminescent layer.
The hole transport layer is preferably formed by a wet film-forming method from the standpoint of, for example, uniformly covering the hole injection layer and furthermore, washing out or covering fine extraneous materials due to an anode-derived projection, a particle or the like.
The hole transport layer 4 can be formed on the hole injection layer 3 when the hole injection layer is provided and can be formed on the anode 2 when the hole injection layer 3 is not provided. The organic electroluminescence element of the present invention may have a configuration where the hole transport layer is omitted.
The material for forming the hole transport layer 4 is preferably a material having high hole transportability and being capable of efficiently transporting the injected hole. Accordingly, the material preferably has small ionization potential, high transparency to visible light, large hole mobility and excellent stability and scarcely generates impurities, which may become trapped during production or use. Also, in many cases, the hole transport layer is in contact with a luminescent layer 5 and therefore, the material preferably involves no quenching of light emitted from the luminescent layer 5 or no formation of an exciplex with the luminescent layer 5 to reduce the efficiency.
The material of the hole transport layer 4 may be a material conventionally used as a constituent material of the hole

transport layer, and examples thereof include those described above as examples of the hole transporting compound for use in the hole injection layer 3. Other examples include an aromatic diamine containing two or more tertiary amines, in which two or more fused aromatic rings are substituted on the nitrogen atom, typified by 4,4'-bis[N-(1-naphthhyl)-N-phenylamino]biphenyl (JP-A-5-234681); an aromatic amine compound having a starburst structure, such as 4,4',4"-tris (1-naphthylphenylamino)triphenylamine (J. Lumin., Vol. 72-74, page 985, 1997); an aromatic amine compound composed of a tetramer of triphenylamine (Chem. Commun., page 2175, 1996); a spiro compound such as 2,2',7,7'-tetrakis-(diphenylamino)-9,9'-spirobifluorene (Synth. Metals, Vol. 91, page 209, 1997); and a carbazole derivative such as 4,4'-N,N'-dicarbazolebiphenyl. Still other examples include polyvinylcarbazole, polyvinyltriphenylamine (JP-A-7-53953), and tetraphenylbenzidine-containing polyarylene ether sulfone (Polym. Adv. Tech., Vol. 7, page 33, 1996).

In the case of forming the hole transport layer 4 by wet deposition, similarly to the formation of the hole injection layer 3, a composition for formation of a hole transport layer is prepared, then coated/film-formed and dried by heating. The composition for formation of a hole transport layer contains a solvent in addition to the above-described hole transporting compound. The solvent used is the same as that used in the composition for formation of a hole injection layer. The film formation conditions, heating and drying conditions and the like are also the same as in the formation of the hole injection layer 3.

In the case of forming the hole transport layer by vacuum deposition, the deposition conditions and the like are also the same as in the formation of the hole injection layer 3.

The hole transport layer 4 may contain various luminescent materials, electron transporting compounds, binder resins, coatability improvers and the like, in addition to the hole transporting compound.

The hole transport layer 4 may be a layer formed by crosslinking a crosslinking compound. The crosslinking compound is a compound having a crosslinking group and forms a polymer by undergoing crosslinking. The crosslinking compound may be any of a monomer, an oligomer and a polymer. Only one kind of a crosslinking compound may be used, or two or more kinds of crosslinking compounds may be used in an arbitrary combination in an arbitrary ratio.

Examples of the crosslinking group of the crosslinking compound include a cyclic ether such as oxetane and epoxy; an unsaturated double bond such as vinyl group, trifluorovinyl group, styryl group, acryl group, methacryloyl and cinnamoyl; and benzocyclobutane.

The crosslinking compound, that is, a monomer, oligomer or polymer having a crosslinking group, is not particularly limited in the number of crosslinking groups contained therein, but the number of crosslinking groups is usually less than 2.0, preferably 0.8 or less, more preferably 0.5 or less, per unit charge transport unit. This is set so as to adjust the dielectric constant of the hole transport layer-forming material to a suitable range. Also, the range above is set because if the number of crosslinking groups is too large, a reaction active species is generated and may adversely affect other materials. The unit charge transport unit as used herein is a monomer form itself when the material forming the crosslinking polymer is a monomer form, and the unit indicates a skeleton excluding the crosslinking group (main skeleton). In the case of mixing other kinds of monomers, the unit also indicates the main skeleton of each monomer.

In the case where the material forming the crosslinking polymer is an oligomer or polymer, when a structure having an organochemically interrupted conjugation is repeated, the unit charge transport unit indicates the repetitive structure. Also, in the case of a structure where the conjugation is widely connected, the unit indicates a minimum repetitive structure having charge transportability or a monomer structure. Examples thereof include polycyclic aromatics such as naphthalene, anthracene, phenanthrene, tetracene, chrysene, pyrene and perylene, fluorene, triphenylene, carbazole, triarylamine, tetraarylbenzidine, and 1,4-bis(diarylamino)benzene.

Furthermore, a hole transporting compound having a crosslinking group is preferably used as the crosslinking compound. Examples of the hole transporting compound here include a nitrogen-containing aromatic compound derivative such as pyridine derivative, pyrazine derivative, pyrimidine derivative, triazine derivative, quinoline derivative, phenanthroline derivative, carbazole derivative, phthalocyanine derivative and porphyrin derivative; a triphenylamine derivative; a silole derivative; an oligothiophene derivative; a condensed polycyclic aromatic derivative; and a metal complex. Among these, a nitrogen-containing aromatic derivative such as pyridine derivative, pyrazine derivative, pyrimidine derivative, triazine derivative, quinoline derivative, phenanthroline derivative and carbazole derivative, a triphenylamine derivative, a silole derivative, a condensed polycyclic aromatic derivative, and a metal complex are preferred, and a triphenylamine derivative is more preferred.

The molecular weight of the crosslinking compound is usually 5,000 or less, preferably 2,500 or less, and is preferably 300 or more, more preferably 500 or more.

For forming the hole transport layer 4 by crosslinking a crosslinking compound, usually, a hole transport layer-forming composition in which the crosslinking compound is dissolved or dispersed in a solvent is prepared and film-formed by a wet film-forming method and thereafter, the crosslinking compound is crosslinked.

The composition for formation of a hole transport layer may contain an additive for accelerating the crosslinking reaction, in addition to the crosslinking compound. Examples of the additive for accelerating the crosslinking reaction include a polymerization initiator and a polymerization accelerator, such as alkylphenone compound, acylphosphine oxide compound, metallocene compound, oxime ester compound, azo compound and onium salt; and a photosensitizer

such as condensed polycyclic hydrocarbon, porphyrin compound and diaryl ketone compound. One kind of these additives may be used alone, or two or more kinds thereof may be used in an arbitrary combination in an arbitrary ratio.
The composition for formation of a hole transport layer may further contain a coatability improver such as leveling agent and defoaming agent, an electron accepting compound, a binder resin and the like.
The composition for formation of a hole transport layer contains the crosslinking compound in an amount of usually 0.01 wt% or more, preferably 0.05 wt% or more, more preferably 0.1 wt% or more, and usually 50 wt% or less, preferably 20 wt% or less, more preferably 10 wt% or less.
The hole transport layer-forming composition containing a crosslinking compound in such a concentration is film-formed on the underlying layer (usually, a hole injection layer 3) and then, polymerized by crosslinking the crosslinking compound under heating and/or by the irradiation with electromagnetic energy such as light.
The conditions such as temperature and humidity at the film formation are the same as those at the wet deposition of the hole injection layer 3.

The method for heating after film formation is not particularly limited, but examples thereof include drying by heating and drying under reduced pressure. The heating temperature condition in the drying by heating is usually 120˚C or more and is preferably 400˚C or less.
The heating time is usually 1 minute or more and is preferably 24 hours or less. The heating device is not particularly limited but, for example, the laminate having the deposited layer is placed on a hot plate or heated in an oven. For example, conditions such as heating on a hot plate at 120˚C or more for 1 minute or more may be employed.
In the case of irradiation with electromagnetic energy such as light, examples of the method include a method of irradiating light by directly using an ultraviolet, visible or infrared light source such as ultrahigh pressure mercury lamp, high pressure mercury lamp, halogen lamp and infrared lamp, and a method of irradiating light by using a mask aligner having incorporated thereinto the light source described above or using a conveyor-type light irradiation apparatus. The method for irradiation with electromagnetic energy other than light includes, for example, irradiation using an apparatus capable of irradiating a microwave generated by a magnetron, that is, a so-called microwave oven. As for the irradiation time, the condition necessary to reduce the solubility of the film is preferably set, but the electromagnetic energy is irradiated usually for 0.1 second or more and preferably for 10 hours or less.
Heating and irradiation with electromagnetic energy such as light may be performed individually or in combination. In the case of combining these treatments, the order of practicing them is not particularly limited.
The thickness of the thus-formed hole transport layer 4 is usually 5 nm or more, preferably 10 nm or more, and is usually 300 nm or less, preferably 100 nm or less.

[Luminescent Layer]

A luminescent layer 5 is provided on the hole injection layer 3 or when a hole transport layer 4 is provided, on the hole transport layer 4. The luminescent layer 5 is a layer which becomes a main luminous source by being excited when a hole injected from the anode 2 and an electron injected from the cathode 9 are recombined between electrodes to which an electric field is applied.

<Material of Luminescent Layer>

The luminescent layer 5 contains, as its constituent material, at least a material having luminescence property (luminescent material) and at the same time, preferably contains a compound having hole transportability (hole transporting compound) or a compound having electron transportability (electron transporting compound). It is also possible to use a luminescent material as the dopant material and use a hole transporting compound, an electron transporting compound or the like as the host material. The luminescent material is not particularly limited, and a substance capable of emitting light at the desired emission wavelength and giving good luminous efficiency may be used. Furthermore, the luminescent layer 5 may contain other components within the range not seriously impairing the effects of the present invention. Incidentally, in the case of forming the luminescent layer 5 by a wet film-forming method, a material having a low molecular weight is preferably used for all constituent materials.
In the organic electroluminescence element of the present invention, the luminescent layer 5 is formed using the above-described composition for organic electroluminescence elements of the present invention. Therefore, specific examples of the luminescent material, charge transporting compound and hole transporting compound contained in the luminescent layer 5 according to the present invention are the same as those described above as specific examples of the luminescent material and charge transport material contained in the composition for organic electroluminescence elements of the present invention, and for each material or compound, only any one kind may be used, or two or more kinds may be used in an arbitrary combination in an arbitrary ratio.

For forming the luminescent layer 5 by using the composition for organic electroluminescence elements of the present invention, the composition for organic electroluminescence elements is coated and film-formed, and the obtained

coating film is dried to remove the solvent. The mode of the wet film-forming method is not limited as long as the effects of the present invention are not seriously impaired, and any of the above-described modes can be used. The specific method for wet deposition is the same as the method described in the formation of the hole injection layer 3.

The thickness of the thus-formed luminescent layer 5 may be arbitrarily set as long as the effects of the present invention are not seriously impaired, but the thickness is usually 3 nm or more, preferably 5 nm or more, and is usually 200 nm or less, preferably 100 nm or less. If the thickness of the luminescent layer 5 is too small, a defect may be produced in the film, whereas if it is excessive large, the drive voltage may rise.

The content ratio of the luminescent material in the luminescent layer 5 may be arbitrarily set as long as the effects of the present invention are not seriously impaired, but the content is usually 0.05 wt% or more and is usually 35 wt% or less. If the content of the luminescent material is too small, uneven light emission may be produced, whereas if it is excessively large, the luminous efficiency may decrease. In the case of using two or more kinds of luminescent materials in combination, the total content thereof is set to fall in the range above.

Also, in the case where the luminescent layer 5 contains an electron transporting compound, the content ratio of the electron transporting compound in the luminescent layer 5 may be arbitrarily set as long as the effects of the present invention are not seriously impaired, but the content is usually 0.1 wt% or more and is usually 65 wt% or less. If the content of the electron transporting compound is too small, the layer may be susceptible to the effect of short circuit, whereas if it is excessively large, uneven thickness may be produced. In the case of using two or more kinds of electron transporting compounds in combination, the total content thereof is set to fall in the range above.

In the case where the luminescent layer 5 contains a hole transporting compound, the ratio of the hole transporting compound in the luminescent layer 5 may be arbitrarily set as long as the effects of the present invention are not seriously impaired, but the content is usually 0.1 wt% or more and is usually 65 wt% or less. If the content of the hole transporting compound is too small, the layer may be susceptible to the effect of short circuit, whereas if it is excessively large, uneven thickness may be produced. In the case of using two or more kinds of hole transporting compounds in combination, the total content thereof is set to fall in the range above.

[Hole Blocking Layer]

A hole blocking layer 6 may be provided between the luminescent layer 5 and the later-described electron injection layer 8.

The hole blocking layer 6 is a layer laminated on the luminescent layer 5 to come into contact with the interface on the cathode 9 side of the luminescent layer 5.

The hole blocking layer 6 has the role of blocking a hole moving from the anode 2 to reach the cathode 9 and efficiently transporting an electron injected from the cathode 9 toward the luminescent layer 5.

The physical properties required of the material constituting the hole blocking layer 6 include high electron mobility, low hole mobility, large energy gap (difference between HOMO and LUMO) and high triplet excited level (T1). Examples of the hole blocking layer 6 material satisfying these conditions include a mixed ligand complex such as bis(2-methyl-8-quinolinolato)(phenolato)aluminum and bis(2-methyl-8-quinolinolato)(triphenylsilanolato)aluminum, a metal complex such as bis(2-methyl-8-quinolate)aluminum-$\mu$-oxo-bis-(2-methyl-8-quinolilato)aluminum binuclear metal complex, a styryl compound such as distyrylbiphenyl derivative (JP-A-11-242996), a triazole derivative such as 3-(4-biphenylyl)-4-phenyl-5(4-tert-butylphenyl)-1,2,4-triazole (JP-A-7-41759), and a phenanthroline derivative such as bathocuproine (JP-A-10-79297). Furthermore, a compound having at least one pyridine ring substituted at 2-, 4- and 6-positions described in International Publication No. 2005-022962, pamphlet, is also preferred as the material of the hole blocking layer 6.

Of the materials for the hole blocking layer 6, only one kind of a material may be used, or two or more kinds of materials may be used in an arbitrary combination in an arbitrary ratio.

The method for forming the hole blocking layer 6 is not limited, and a wet film-forming method, a vapor deposition method and other methods can be employed.

The film thickness of the hole blocking layer 6 may be arbitrarily set as long as the effects of the present invention are not seriously impaired, but the thickness is usually 0.3 nm or more, preferably 0.5 nm or more and is usually 100 nm or less, preferably 50 nm or less.

[Electron Transport Layer]

An electron transport layer 7 may be provided between the luminescent layer 5 and the later-described electron injection layer 8.

The electron transport layer 7 is provided for the purpose of further enhancing the luminous efficiency of the element and is formed of a compound capable of efficiently transporting an electron injected from the cathode 9 toward the luminescent layer 5 between the electrodes to which an electric field is applied.

As for the electron transporting compound used in the electron transport layer 7, a compound having high electron

injection efficiency from the cathode 9 or the electron injection layer 8 and high electron mobility and being capable of efficiently transporting the injected electron is used. Examples of the compound satisfying these conditions include a metal complex such as aluminum complex of 8-hydroxyquinoline (JP-A-59-194393), a metal complex of 10-hydroxybenzo[h]quinoline, an oxadiazole derivative, a distyrylbiphenyl derivative, a silole derivative, a 3-hydroxyflavone metal complex, a 5-hydroxyflavone metal complex, a benzoxazole metal complex, a benzothiazole metal complex, trisbenzimidazolylbenzene (U.S. Patent 5,645,948), a quinoxaline compound (JP-A-6-207169), a phenanthroline derivative (JP-A-5-331459), 2-tert-butyl-9,10-N,N'-dicyanoanthraquinonediimine, n-type hydrogenated amorphous silicon carbide, n-type zinc sulfide, and n-type zinc selenide.
Of the materials for the electron transport layer 7, only one kind of a material may be used, or two or more kinds of materials may be used in an arbitrary combination in an arbitrary ratio.
The method for forming the electron transport layer 7 is not limited, and a wet film-forming method, a vapor deposition method and other methods can be employed.
The film thickness of the electron transport layer 7 may be arbitrarily set as long as the effects of the present invention are not seriously impaired, but the film thickness is usually 1 nm or more, preferably 5 nm or more and is usually 300 nm or less, preferably 100 nm or less.

[Electron Injection Layer]

The electron injection layer 8 has the role of efficiently injecting an electron injected from the cathode 9, into the luminescent layer 5. In order to efficiently perform the electron injection, the material forming the electron injection layer 8 is preferably a metal having a low work function. Examples thereof include an alkali metal such as sodium and cesium, and an alkaline earth metal such as barium and calcium. The film thickness of the layer is usually 0.1 nm or more and is preferably 5 nm or less.
Furthermore, an organic electron transport compound typified by a nitrogen-containing heterocyclic compound such as bathophenanthroline and a metal complex such as aluminum complex of 8-hydroxyquinoline is preferably doped with an alkali metal such as sodium, potassium, cesium, lithium and rubidium (described, for example, in JP-A-10-270171, JP-A-2002-100478 and JP-A-2002-100482), because both enhanced electron injection/transport performance and excellent film quality can be achieved. In this case, the film thickness is usually 5 nm or more, preferably 10 nm or more and is usually 200 nm or less, preferably 100 nm or less.
Of the materials for the electron injection layer 8, only one kind of a material may be used, or two or more kinds of materials may be used in an arbitrary combination in an arbitrary ratio.
The method for forming the electron injection layer 8 is not limited, and a wet film-forming method, a vapor deposition method and other methods can be employed.

[Cathode]

The cathode 9 has the role of injecting an electron into the layer (for example, the electron injection layer 8 or the luminescent layer 5) on the luminescent layer 5 side.
As for the material of the cathode 9, the materials for use in the anode 2 may be used, but in order to efficiently perform the electron injection, a metal having a low work function is preferred, and an appropriate metal such as tin, magnesium, indium, calcium, aluminum and silver, or an alloy thereof is used. Specific examples thereof include an alloy electrode having a low work function, such as magnesium-silver alloy, magnesium-indium alloy and aluminum-lithium alloy.
Of the materials for the cathode 9, only one kind of a material may be used, or two or more kinds of materials may be used in an arbitrary combination in an arbitrary ratio.
The film thickness of the cathode 9 is usually the same as that of the anode 2.
For the purpose of protecting the cathode 9 formed of a metal having a low work function, a metal layer having a high work function and being stable to the air is preferably further laminated thereon, because the stability of the element is increased. A metal such as aluminum, silver, copper, nickel, chromium, gold and platinum is used to this end. Of these materials, only one kind of a material may be used, or two or more kinds of materials may be used in an arbitrary combination in an arbitrary ratio.

[Other Layers]

The organic electroluminescence element of the present invention may have other configurations without departing from its purpose. For example, the element may have an arbitrary layer between the anode 2 and the cathode 9 in addition to the layers described above as long as the performance thereof is not impaired. Also, an arbitrary layer may be omitted.
The layer which the element may have other than the layers described above includes, for example, an electron blocking

layer.
The electron blocking layer is provided between the hole injection layer 3 or hole transport layer 4 and the luminescent layer 5 and has the role of blocking an electron moving from the luminescent layer 5 to reach the hole injection layer 3, thereby increasing the probability of recombination of a hole and an electron in the luminescent layer 5 and confining the produced exciton in the luminescent layer 5, and the role of efficiently transporting a hole injected from the hole injection layer 3 toward the luminescent layer 5. In particular, when a phosphorescent material or a blue luminescent material is used as the luminescent material, it is effective to provide an electron blocking layer.

The properties required of the electron blocking layer include high hole transportability, large energy gap (difference between HOMO and LUMO) and high triplet excited level (T1). Furthermore, in the present invention, in the case of producing the luminescent layer 5 by a wet film-forming method using the composition for organic electroluminescence elements of the present invention, the electron blocking layer is also required to have wet deposition compatibility. Examples of the material used for such an electron blocking layer include a copolymer of dioctylfluorene and triphenylamine, typified by F8-TFB (described in International Publication No. 2004/084260).
Of the materials for the electron blocking layer, only one kind of a material may be used, or two or more kinds of materials may be used in an arbitrary combination in an arbitrary ratio.
The method for forming the electron blocking layer is not limited, and a wet film-forming method, a vapor deposition method and other methods can be employed.

It is also an effective method for enhancing the element efficiency to insert an ultrathin insulating film (from 0.1 to 5 nm) formed of, for example, lithium fluoride (LiF), magnesium fluoride ($MgF_2$), lithium oxide ($Li_2O$) or cesium(II) carbonate ($CsCO_3$) into the interface between the cathode 9 and the luminescent layer 5 or the electron transport layer 7 (see, for example, Applied Physics Letters, Vol. 70, page 152 (1997); JP-A-10-74586; IEEE Transactions on Electron Devices, Vol. 44, page 1245 (1997); and SID 04 Digest, page 154).
Furthermore, in the layer configuration described above, the constituent elements except for the substrate may be laminated in reverse order. For example, as concerns the layer configuration of Fig. 1, other constituent elements may be provided on the substrate 1 in the order of a cathode 9, an electron injection layer 8, an electron transport layer 7, a hole blocking layer 6, a luminescent layer 5, a hole transport layer 4, a hole injection layer 3 and an anode 2.

In addition, the organic electroluminescence element of the present invention can be configured by laminating constituent elements except for the substrate between two substrates with at least one substrate having transparency.
A structure where constituent elements (luminescent unit) except for the substrate are layered in a plurality of tiers (a structure where a plurality of luminescent units are laminated) may be also employed. At this time, when a carrier generation layer (CGL) composed of, for example, vanadium pentoxide ($V_2O_5$) is provided in place of an interface layer (when the anode is ITO and the cathode is Al, these two layers) between respective tiers (between luminescent units), the barrier between tiers is reduced and this more preferred in view of luminous efficiency and drive voltage.
Also, the organic electroluminescence element of the present invention may be configured as a single organic electroluminescence element, may be applied to a configuration where a plurality of organic electroluminescence elements are arranged in an array manner, or may be applied to a configuration where the anode and the cathode are arranged in an X-Y matrix manner.
In each of the above-described layers, components other than those described as the material may be contained as long as the effects of the present invention are not seriously impaired.

[Organic EL display]

The organic EL display of the present invention uses the organic electroluminescence element of the present invention described above. The organic EL display of the present invention is not particularly limited in its mode or structure and can be fabricated according to a conventional method by using the organic electroluminescence element of the present invention.
For example, the organic EL display of the present invention can be fabricated by such a method as described in Seishi Tokito, Chihaya Adachi and Hideyuki Murata, Yuki EL Display (Organic EL Display), Ohm-Sha (August 20, 2004).

[Organic EL lighting]

The organic EL lighting of the present invention uses the organic electroluminescence element of the present invention described above. The organic EL lighting of the present invention is not particularly limited in its mode or structure and can be fabricated according to a conventional method by using the organic electroluminescence element of the present invention.

EXAMPLES

The present invention is described in greater detail below by referring to Examples, but the present invention is not limited to the following Examples as long as the features claimed below are the present inventionobserved.
In the following Examples and Comparative Examples, the saturated solubility for toluene at 20˚C and 1 atom of each compound as the organic electroluminescence element material in the composition for organic electroluminescence elements used for the formation of the luminescent layer is as shown in Table 1 below.
[Table 1]

| Compound | Saturated Solubility (wt%) for Toluene at 20˚C and 1 atm |
|---|---|
| E-1 | 1.7 |
| E-2 | 1.2 |
| D-1 | 1.0 |
| D-2 | 2 |
| D-3 | 10 |

[Example 1]

The organic electroluminescence element shown in Fig. 1 was fabricated.
A glass substrate having film-formed thereon an indium tin oxide (ITO) transparent electroconductive film having a thickness of 150 nm (sputtering-deposited product, sheet resistance: 15 Ω) was patterned by normal photolithography technique to form an anode 2 as a 2 mm-wide stripe. The substrate 1 with the anode 2 formed was washed successively by ultrasonic cleaning with acetone, washing with pure water, and ultrasonic cleaning with isopropyl alcohol, then dried by nitrogen blowing, and finally subjected to a treatment such as ultraviolet-ozone cleaning.
On the substrate after the treatment, a hole injection layer 3 was formed as follows.
A hole injection layer-forming composition containing Aromatic Amine-Based Polymer Compound PB-1 having a repetitive structure shown below (weight average molecular weight: 29,400, number average molecular weight: 12,600) and Electron Accepting Compound PI-1 having a structure shown below as hole injection materials and containing ethyl benzoate as a solvent was prepared. In the hole injection layer-forming composition, the total concentration of Aromatic Amine-Based Polymer Compound PB-1 and Electron Accepting Compound PI-1 was 2 wt%, and the weight ratio between Aromatic Amine-Based Polymer Compound PB-1 and Electron Accepting Compound PI-1 was (Aromatic Amine-Based Polymer Compound PB-1) : (Electron Accepting Compound PI-1) = 10:4.
[Chem. 18]

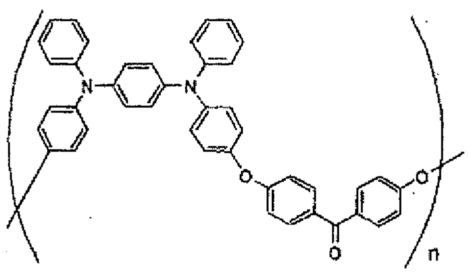

(PB-1)

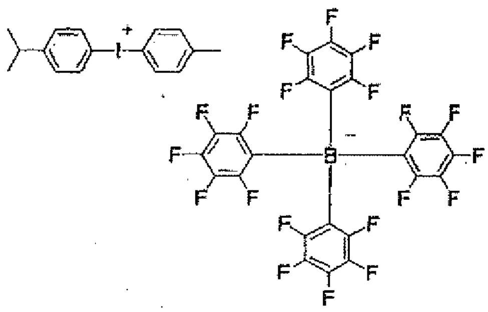

(PI-1)

The hole injection layer-forming composition was spin-coated on the substrate after the treatment above at a spinner rotation speed of 1,500 rpm and a spinner rotation time of 30 seconds and then dried under heating at 260°C for 180 minutes.
By the operation above, the hole injection layer 3 was formed as a uniform thin film having a thickness of 30 nm.
On the formed hole injection layer 3, a hole transport layer 4 was formed as follows.
A hole transport layer-forming composition containing Polymer Compound HT-1 (weight average molecular weight: 17,000, number average molecular weight: 9,000) having a repetitive structure shown below and toluene as a solvent was prepared. In the hole transport layer-forming composition obtained, the concentration of Polymer Compound HT-1 was 0.4 wt%.
[Chem. 19]

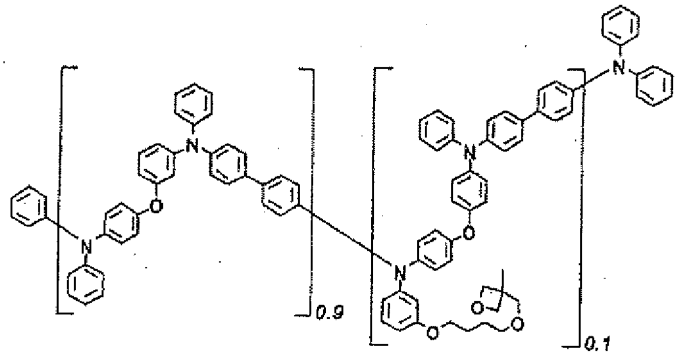

(HT-1)

The hole transport layer-forming composition was spin-coated on the hole injection layer 3 at a spinner rotation speed of 1,500 rpm for a spinner rotation time of 30 seconds and then cured by heating it at 230°C for 60 minutes and thereby causing a crosslinking reaction of Polymer Compound HT-1.

By the operation above, the hole transport layer 4 was formed as a uniform thin film having a thickness of 20 nm.

On the formed hole transport layer 4, a luminescent layer 5 was formed as follows.

For the formation of the luminescent layer 5, the composition for organic electroluminescence elements of the present invention was used. That is, a composition for organic electroluminescence elements, containing Compound D-1 having a structure shown below as a luminescent material (dopant material) and Compound E-1 having a structure shown below as a charge transport material (host material) was prepared.

[Chem. 20]

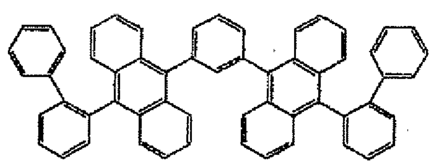

(E-1)

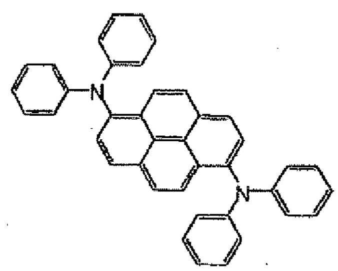

(D-1)

In the composition for organic electroluminescence elements, the total concentration of Compound D-1 and Compound E-1 was 2.3 wt%, and the weight ratio between Compound D-1 and Compound E-1 was (Compound D-1) : (Compound E-1) = 1:20.

Incidentally, the saturated solubility for cyclohexylbenzene at 20°C and 1 atm of Compound D-1 is 0.25 wt% and that of Compound E-1 is 2.5 wt%.

Furthermore, when the organic electroluminescence element material having a largest weight (EL material N) in the composition for organic electroluminescence elements is assigned to Compound E-1 and the organic electroluminescence element material having a smallest weight (EL material S) is assigned to Compound D-1, the parameter value of the present invention calculated by formula (1) was 2.0.

With respect to this composition for organic electroluminescence elements, the saturated solubility of each organic electroluminescence element material for the solvent in the composition, the weight ratio and the parameter value of the present invention are shown in Table 2 below.

The composition for organic electroluminescence elements was spin-coated on the hole transport layer 4 at a spinner rotation speed of 1,000 rpm for a spinner rotation time of 30 seconds and then dried by heating at 130°C for 60 minutes.

By the operation above, the luminescent layer 5 was formed as a uniform thin film having a thickness of 40 nm.
On the formed luminescent layer 5, Compound HB-1 as a hole blocking layer 6 was formed to a film thickness of 10 nm by a vacuum deposition method.

[Chem. 21]

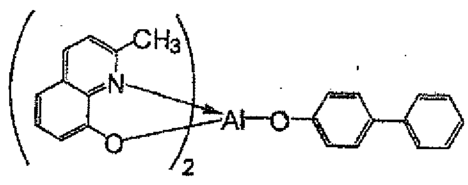

(HB-1)

On the formed hole blocking layer 6, Compound ET-1 as an electron transport layer 7 was formed to a film thickness of 30 nm by a vacuum deposition method.

[Chem. 22]

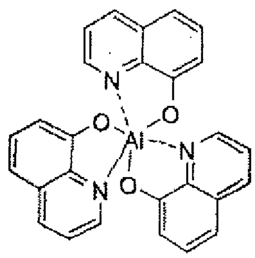

(ET-1)

On the formed electron transport layer 7, lithium fluoride (LiF) as an electron injection layer 8 was formed to a film thickness of 0.5 nm by a vacuum deposition method and aluminum as a cathode 9 was formed to a film thickness of 80 nm by a vacuum deposition method as a 2 mm-wide stripe crossing the anode 2.
In this way, an organic electroluminescence element having a luminescent portion with an area of 2 mm × 2 mm in size was obtained.
It was confirmed that blue-light emission having an EL peak wavelength of 462 nm is obtained from the obtained element.
Using this element, a drive test with constant current driving with an initial luminance of 500 cd/$m^2$ was performed under the room temperature condition, and as a result, the time taken for the front luminance to decrease by half (luminance half life) was 500 hours. Also, the drive voltage at the front luminance of 100 cd/$m^2$ was 5.6 V.
The results are shown in Table 2 below.

[Comparative Example 1]

An organic electroluminescence element was obtained in the same manner as in Example 1 except that the weight ratio between the luminescent material (Compound D-1) and the charge transport material (Compound E-1) contained in the composition for organic electroluminescence elements used when forming the luminescent layer 5 was set to (Compound D-1) : (Compound E-1) = 1:10.
When the organic electroluminescence element material having a largest weight (EL material N) in the composition for organic electroluminescence elements is assigned to Compound E-1 and the organic electroluminescence element material having a smallest weight (EL material S) is assigned to Compound D-1, the parameter value of the present invention calculated by formula (1) was 1.0.
With respect to this composition for organic electroluminescence elements, the saturated solubility of each organic

electroluminescence element material for the solvent in the composition, the weight ratio and the parameter value of the present invention are shown in Table 2.
It was confirmed that blue-light emission having an EL peak wavelength of 465 nm is obtained from the obtained element. Using this element, a drive test with constant current driving with an initial luminance of 500 cd/$m^2$ was performed under the room temperature condition, and as a result, the time taken for the front luminance to decrease by half (luminance half life) was 220 hours. Also, the drive voltage at the front luminance of 100 cd/$m^2$ was 7.0 V.
The results are shown in Table 2 below.

[Example 2]

An organic electroluminescence element was obtained in the same manner as in Example 1 except that Polymer Compound HT-2 having a repetitive structure shown below (weight average molecular weight: 38,000, number average molecular weight: 18,000) was used in place of Polymer Compound HT-1 as the polymer compound for use in the hole transport layer-forming composition, a luminescent material having a structure shown below (Compound D-2) was used in place of the luminescent material (Compound D-1) contained in the composition for organic electroluminescence elements used when forming the luminescent layer 5, and the weight ratio between the luminescent material (Compound D-2) and the charge transport material (Compound E-1) was set to (Compound D-2) : (Compound E-1) = 1:10.
[Chem. 23]

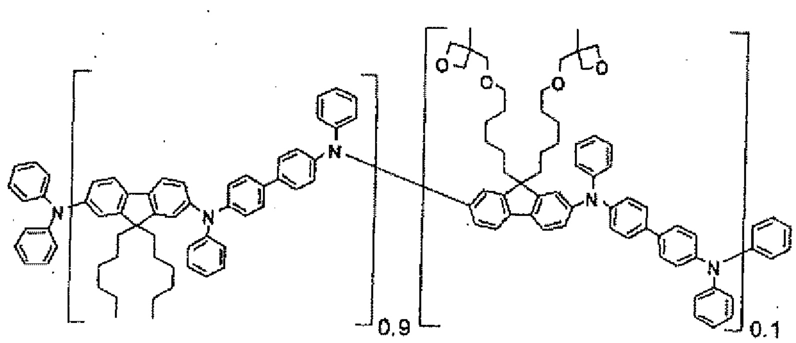

(HT-2)

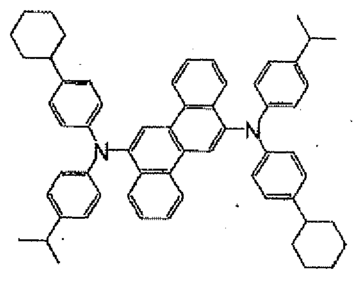

(D-2)

Incidentally, the saturated solubility for cyclohexylbenzene at 20˚C and 1 atm of Compound D-2 is 2.5 wt%. When the organic electroluminescence element material having a largest weight (EL material N) in the composition for organic electroluminescence elements is assigned to Compound E-1 and the organic electroluminescence element material having a smallest weight (EL material S) is assigned to Compound D-2, the parameter value of the present invention calculated by formula (1) was 10.0.
With respect to this composition for organic electroluminescence elements, the saturated solubility of each organic electroluminescence element material for the solvent in the composition, the weight ratio and the parameter value of the present invention are shown in Table 2.
It was confirmed that blue-light emission having an EL peak wavelength of 464 nm is obtained from the obtained element. Using this element, a drive test with constant current driving with an initial luminance of 500 cd/$m^2$ was performed under the room temperature condition, and as a result, the time taken for the front luminance to decrease by half (luminance half life) was 900 hours. Also, the drive voltage at the front luminance of 100 cd/$m^2$ was 5.1 V.
The results are shown in Table 2 below.

[Example 3]

An organic electroluminescence element was obtained in the same manner as in Example 2 except that a charge transport material having a structure shown below (Compound E-2) was used in place of the charge transport material (Compound E-1) contained in the composition for organic electroluminescence elements used when forming the luminescent layer 5 and the weight ratio between the luminescent material (Compound D-2) and the charge transport material (Compound E-2) was set to (Compound D-2) : (Compound E-2) = 1:10.
[Chem. 24]

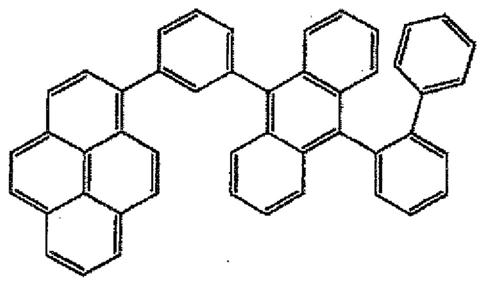

(E−2)

Incidentally, the saturated solubility for cyclohexylbenzene at 20˚C and 1 atm of Compound E-2 is 1.2 wt% and since a solution having a concentration of 2.3 wt% can be hardly prepared at ordinary temperature, a solution obtained by mixing Compound D-2, Compound E-2 and cyclohexylbenzene and heating the mixture on a hot plate set at 80˚C to dissolve Compound E-2 was used before the crystal was again precipitated.
When the organic electroluminescence element material having a largest weight (EL material N) in the composition for organic electroluminescence elements is assigned to Compound E-2 and the organic electroluminescence element material having a smallest weight (EL material S) is assigned to Compound D-2, the parameter value of the present invention calculated by formula (1) was 20.8.
With respect to this composition for organic electroluminescence elements, the saturated solubility of each organic electroluminescence element material for the solvent in the composition, the weight ratio and the parameter value of the present invention are shown in Table 2.
It was confirmed that blue-light emission having an EL peak wavelength of 464 nm is obtained from the obtained element. Using this element, a drive test with constant current driving with an initial luminance of 500 cd/$m^2$ was performed under the room temperature condition, and as a result, the time taken for the front luminance to decrease by half (luminance half life) was 2,440 hours. Also, the drive voltage at the front luminance of 100 cd/$m^2$ was 6.0 V. The results are shown in Table 2 below.
[Table 2]

| | EL Material N | | | EL Material S | | | Parameter Value of the Invention | Drive Voltage (V) | Luminance Half Life* (hours) |
|---|---|---|---|---|---|---|---|---|---|
| | Kind | Saturated Solubility (wt%) | Weight Ratio | Kind | Saturated Solubility (wt%) | Weight Ratio | | | |
| Example 1 | E-1 | 2.5 | 20 | D-1 | 0.25 | 1 | 2.0 | 5.6 | 500 |
| Example 2 | E-1 | 2.5 | 10 | D-2 | 2.5 | 1 | 10.0 | 5.1 | 900 |
| Example 3 | E-2 | 1.2 | 10 | D-2 | 2.5 | 1 | 20.8 | 6.0 | 2440 |
| Comparative Example 1 | E-1 | 2.5 | 10 | D-1 | 0.25 | 1 | 1.0 | 7.0 | 220 |

* A drive test under the condition of an initial luminance of 500 $cd/m^2$.

[Example 4]

An organic electroluminescence element was obtained in the same manner as in Example 3 except that Polymer Compound HT-3 having a repetitive structure shown below (weight average molecular weight: 52,000, number average molecular weight: 25,000) was used in place of Polymer Compound HT-2 as the polymer compound for use in the hole transport layer-forming composition.
[Chem. 25]

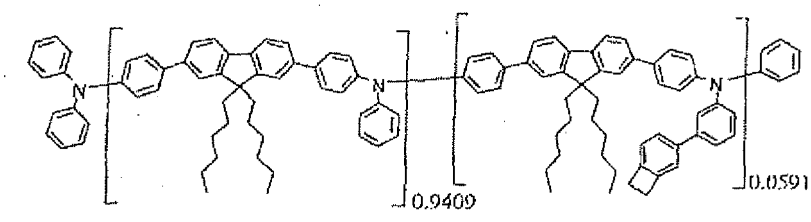

(HT-3)

The organic electroluminescence element material having a largest weight (EL material N) in the composition for organic electroluminescence elements was Compound E-2, the organic electroluminescence element material having a smallest weight (EL material S) was Compound D-2, and the parameter value of the present invention calculated by formula (1) was 20.8 similarly to Example 3.
With respect to this composition for organic electroluminescence elements, the saturated solubility of each organic electroluminescence element material for the solvent in the composition, the weight ratio and the parameter value of the present invention are shown in Table 3.
It was confirmed that blue-light emission having an EL peak wavelength of 464 nm is obtained from the obtained element.
Using this element, a drive test with constant current driving with an initial luminance of 1,000 cd/m$^2$ was performed under the room temperature condition, and as a result, the time taken for the front luminance to decrease by half (luminance half life) was 1,800 hours. Also, the drive voltage at the front luminance of 100 cd/m$^2$ was 5.9 V.
The results are shown in Table 3 below.

[Examples 5 and 6]

Organic electroluminescence elements were obtained in the same manner as in Example 3 except that a luminescent material having a structure shown below (Compound D-3) was used in place of the luminescent material (Compound D-2) contained in the composition for organic electroluminescence elements used when forming the luminescent layer 5 and the mixing weight ratio between Compound E-2 and Compound D-3 was set to 10:1 (Example 5) and 10:0.5 (Example 6), respectively.
Incidentally, the saturated solubility for cyclohexylbenzene at 20°C and 1 atm of Compound D-3 is 12.0 wt%.
Also, the saturated solubility for toluene at 20°C and 1 atm of Compound D-3 is 10.0 wt%.
As to these compositions for organic electroluminescence elements, the saturated solubility of each organic electroluminescence element material for the solvent in the composition, the weight ratio and the parameter value of the present invention are shown in Table 3.
[Chem. 26]

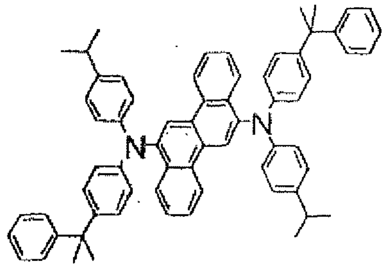

(D−3)

It was confirmed that blue-light emission having an EL peak wavelength of 470 nm is obtained from the element of Example 5.

Using this element, a drive test with constant current driving with an initial luminance of 1,000 cd/$m^2$ was performed under the room temperature condition, and as a result, the time taken for the front luminance to decrease by half (luminance half life) was 1,950 hours. Also, the drive voltage at the front luminance of 100 cd/$m^2$ was 5.7 V.

It was confirmed that blue-light emission having an EL peak wavelength of 468 nm is obtained from the element of Example 6.

Using this element, a drive test with constant current driving with an initial luminance of 1,000 cd/$m^2$ was performed under the room temperature condition, and as a result, the time taken for the front luminance to decrease by half (luminance half life) was 2,310 hours. Also, the drive voltage at the front luminance of 100 cd/$m^2$ was 5.0 V.

The results are shown in Table 3 below.

[Table 3]

| | EL Material N | | | EL Material S | | | Parameter Value of the Invention | Drive Voltage (V) | Luminance Half Life* (hours) |
|---|---|---|---|---|---|---|---|---|---|
| | Kind | Saturated Solubility (wt%) | Weight Ratio | Kind | Saturated Solubility (wt%) | Weight Ratio | | | |
| Example 4 | E-2 | 1.2 | 10 | D-2 | 2.5 | 1 | 20.8 | 5.9 | 1800 |
| Example 5 | E-2 | 1.2 | 10 | D-3 | 12.0 | 1 | 100 | ○○ | 1950 |
| Comparative Example 6 | E-2 | 1.2 | 10 | D-3 | 12.0 | 0.5 | 200 | ○○ | 2310 |

* A drive test under the condition of an initial luminance of 1,000 $cd/m^2$.

[Comparative Example 2]

An organic electroluminescence element was obtained in the same manner as in Comparative Example 1 except that Polymer Compound HT-4 having a structure shown below (weight average molecular weight: 17,000, number average molecular weight: 9,000) was used in place of Polymer Compound HT-1 as the polymer compound for use in the hole transport layer-forming composition, toluene was used as the solvent contained in the composition for organic electroluminescence elements used when forming the luminescent layer 5, Compound E-3 and Compound H-1 each having a structure shown below were used as the charge transport material (host material), Compound D-4 having a structure shown below was used as the luminescent material (dopant material), the mixing weight ratio of Compounds E-3, H-1 and D-4 was set to 10:10:1, and the entire solid content concentration in the composition for organic electroluminescence elements was set to 1.8 wt%.
The saturated solubility for toluene at 20˚C and 1 atm of Compound E-3 is 3 wt%, the saturated solubility of Compound H-1 is 2.5 wt%, and the saturated solubility of Compound D-4 is 0.05 wt%.
It was confirmed that green-light emission having an EL peak wavelength of 510 nm is obtained from the obtained element. Using this element, a drive test was performed under the condition of an initial luminance of 2,500 cd/$m^2$, and as a result, the time taken for the luminance to decrease by half was as short as 340 hours.
Incidentally, the parameter value of the present invention calculated from Compounds E-3 and D-4 was 0.16, and the parameter value of the present invention calculated from Compounds H-1 and D-4 was 0.2.
These results are shown in Table 4 below.

[Chem. 27]

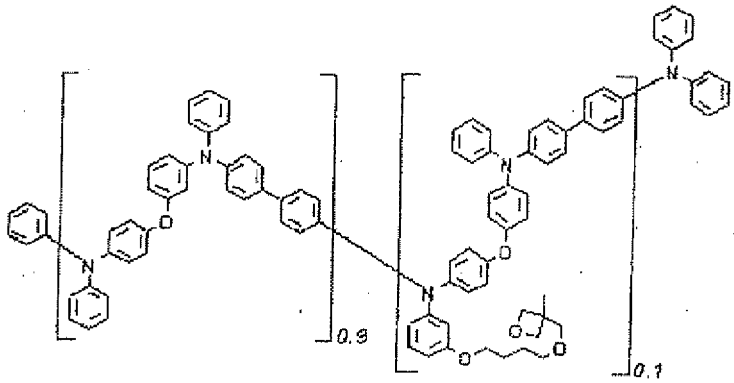

(HT-4)

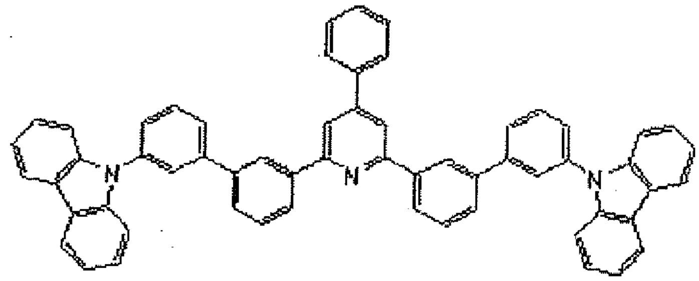

(E-3)

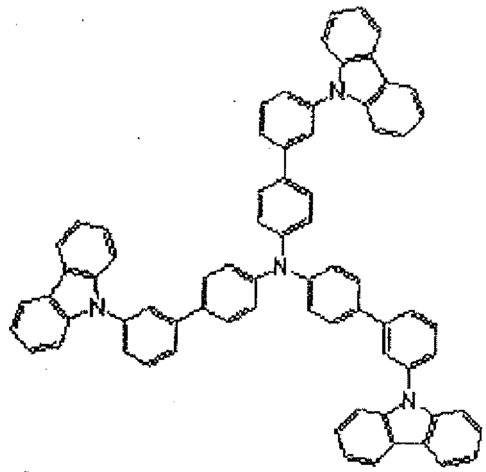

(H-1)

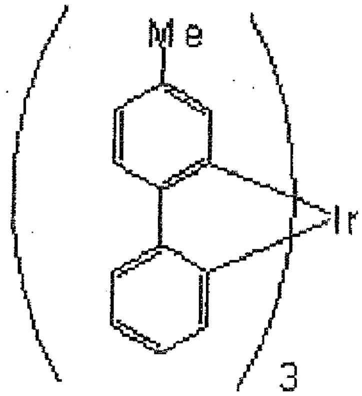

(D-4)

[Example 7]

An organic electroluminescence element was obtained in the same manner as in Example 4 except that Compound E-3 and Compound H-2 having a structure shown below were used as the charge transport material (host material) contained in the composition for organic electroluminescence elements used when forming the luminescent layer 5, Compound D-5 having a structure shown below was used as the luminescent material (dopant material), the mixing weight ratio of Compounds E-3, H-2 and D-5 was set to 5:15:1, and the entire solid content concentration was set to 5.0 wt%.

Incidentally, the saturated solubility for cyclohexylbenzene at 20˚C and 1 atm of Compound D-5 was 5.0 wt%, the saturated solubility of Compound E-3 was 2.5 wt%, and the saturated solubility of Compound H-2 was 1.4 wt%. The solubility of Compound H-2 was low at ordinary temperature and since a solution having an entire solid content concentration of 5.0 wt% (concentration of Compound H-2: 3.57 wt%) could be hardly prepared, a solution obtained by mixing Compounds E-3, H-2, D-5 and cyclohexylbenzene and heating the mixture on a hot plate set at 100˚C to dissolve the materials was used before the crystal was again precipitated.

With respect to this composition for organic electroluminescence elements, the saturated solubility of each organic electroluminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.

[Chem. 28]

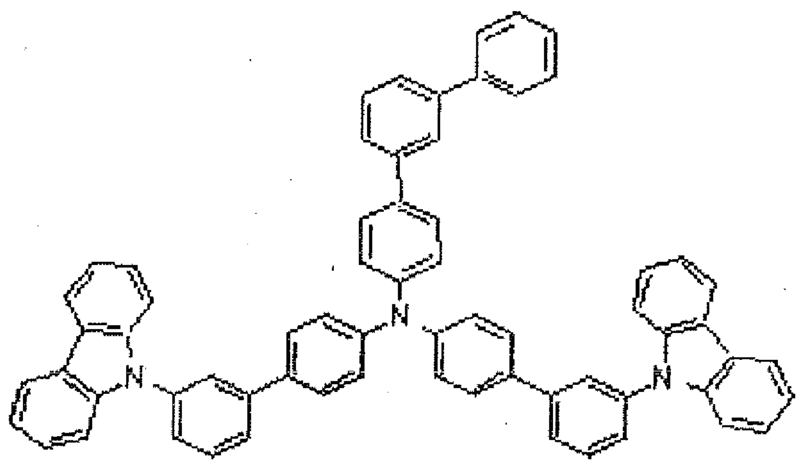

(H−2)

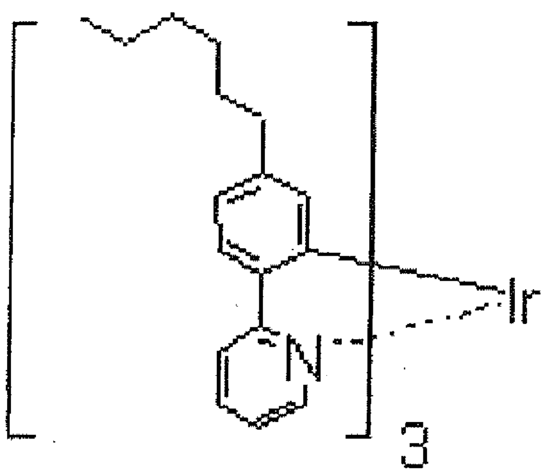

(D−5)

[Example 8]

An organic electroluminescence element was obtained in the same manner as in Example 7 except that Compound E-3 and Compound H-3 having a structure shown below were used as the charge transport material (host material) contained in the composition for organic electroluminescence elements used when forming the luminescent layer 5, Compound D-6 having a structure shown below was used as the luminescent material (dopant material), the mixing weight ratio of Compounds E-3, H-3 and D-6 was set to 15:5:1, and the entire solid content concentration was set to 5.0 wt%.
Incidentally, the saturated solubility for cyclohexylbenzene at 20°C and 1 atm of Compound D-6 was 1.0 wt%, and the saturated solubility of Compound H-3 was 10.0 wt%.
With respect to this composition for organic electroluminescence elements, the saturated solubility of each organic electro luminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.
[Chem. 29]

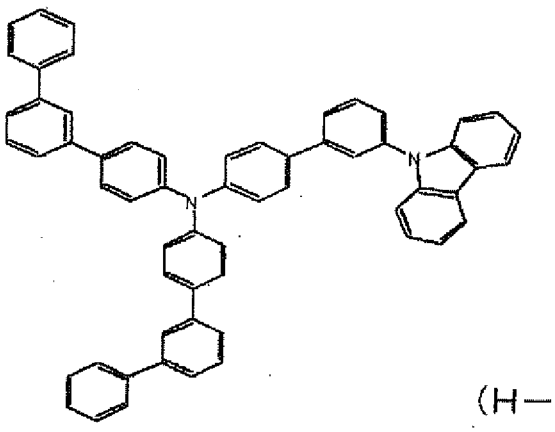
(H−3)

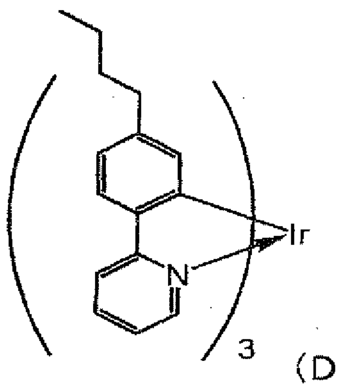
(D−6)

[Example 9]

An organic electroluminescence element was obtained in the same manner as in Example 8 except that in the composition for organic electroluminescence elements used when forming the luminescent layer 5, the mixing weight ratio of Compounds E-3, H-3 and D-6 was set to 15:5:2.
With respect to this composition for organic electroluminescence elements, the saturated solubility of each organic electroluminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.

[Example 10]

An organic electroluminescence element was obtained in the same manner as in Example 8 except that in the composition for organic electroluminescence elements used when forming the luminescent layer 5, the mixing weight ratio of Compounds E-3, H-3 and D-6 was set to 15:5:3.
With respect to this composition for organic electroluminescence elements, the saturated solubility of each organic electroluminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.

[Example 11]

An organic electroluminescence element was obtained in the same manner as in Example 8 except that in the

composition for organic electroluminescence elements used when forming the luminescent layer 5, the mixing weight ratio of Compounds E-3, H-3 and D-6 was set to 15:5:0.5.
With respect to this composition for organic electroluminescence elements, the saturated solubility of each organic electroluminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.

[Comparative Example 3]

An organic electroluminescence element was obtained in the same manner as in Example 8 except that in the composition for organic electroluminescence elements used when forming the luminescent layer 5, the mixing weight ratio of Compounds E-3, H-3 and D-6 was set to 5:15:1.
With respect to this composition for organic electroluminescence elements, the saturated solubility of each organic electroluminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.

[Comparative Example 4]

An organic electroluminescence element was obtained in the same manner as in Example 8 except that in the composition for organic electroluminescence elements used when forming the luminescent layer 5, the mixing weight ratio of Compounds E-3, H-3 and D-6 was set to 12:5:4.
With respect to this composition for organic electroluminescence elements, the saturated solubility of each organic electroluminescence element material for the solvent in the composition, the weight ratio, the parameter value of the present invention, and the time taken for the luminance to decrease by half when performing a drive test under the condition of an initial luminance of 2,500 cd/$m^2$ by using the obtained element are shown in Table 4 below.
[Table 4]

| | EL Material N | | | EL Material S | | | Solvent | Parameter Value of the Invention | Luminance Half Life* (hours) |
|---|---|---|---|---|---|---|---|---|---|
| | Kind | Saturated Solubility (wt%) | Weight Ratio | Kind | Saturated Solubility (wt%) | Weight Ratio | | | |
| Example 7 | E-2 | 1.4 | 15 | D-5 | 5.0 | 1 | cyclohexylbenzene | 53.6 | 1210 |
| Example 8 | E-3 | 2.5 | 15 | D-6 | 1.0 | 1 | cyclohexylbenzene | 6.0 | 1074 |
| Example 9 | E-3 | 2.5 | 15 | D-6 | 1.0 | 2 | cyclohexylbenzene | 3.0 | 1102 |
| Example 10 | E-3 | 2.5 | 15 | D-6 | 1.0 | 3 | cyclohexylbenzene | 2.0 | 882 |
| Example 11 | E-3 | 2.5 | 15 | D-6 | 1.0 | 0.5 | cyclohexylbenzene | 12.0 | 1006 |
| Comparative Example 2 | H-1 | 2.5 | 10 | D-4 | 0.05 | 1 | toluene | 0.2 | 340 |
| | E-3 | 3.0 | 10 | | | | | 0.16 | |
| Comparative Example 3 | H-3 | 10.0 | 15 | D-6 | 1.0 | 1 | cyclohexylbenzene | 1.5 | 452 |
| Comparative Example 4 | E-3 | 2.5 | 12 | D-6 | 1.0 | 4 | cyclohexylbenzene | 1.2 | 690 |

* A drive test under the condition of an initial luminance of 2,500 $cd/m^2$.

It is seen from the above results that an organic electroluminescence element having a long life and requiring a low drive voltage may be realized using the composition for organic electroluminescence elements of the present invention.

While aspects of the invention have been described in detail and with reference to specific embodiments thereof, it will be apparent to one skilled in the art that various changes and modifications can be made therein without departing from the spirit and scope of the invention.

This application is based on Japanese Patent Application (Patent Application No. 2008-198250) filed on July 31, 2008, the contents of which are incorporated herein by way of reference.

INDUSTRIAL APPLICABILITY

According to the present invention, in an organic electroluminescence element having an organic layer such as luminescent layer formed by a wet film-forming method, the deposited organic layer is uniform and excellent in the film quality, so that an organic electroluminescence element having a long life and requiring a low drive voltage can be provided. By using such an organic electroluminescence element, a high-quality organic EL display and a high-quality organic EL lighting can be provided.

DESCRIPTION OF REFERENCE NUMERALS AND SIGNS

1 Substrate
2 Anode
3 Hole injection layer
4 Hole transport layer
5 Luminescent layer
6 Hole blocking layer
7 Electron transport layer
8 Electron injection layer
9 Cathode

**Claims**

1. A composition for an organic electroluminescence element, comprising: two or more kinds of organic electroluminescence element materials; and a solvent, wherein at least one of said organic electroluminescence element materials is a fluorescence-emitting material and the composition satisfies the following formula (1):

[Math. 1]

$$\frac{\text{(Saturated solubility of EL material S)}}{\text{(Weight ratio of EL material S)}} \times \frac{\text{(Weight ratio of EL material N)}}{\text{(Saturated solubility of EL material N)}} \geq 2.0 \quad \ldots (1)$$

(wherein:

EL material S: an organic electroluminescence element material having a smallest weight in said composition,
EL material N: an organic electroluminescence element material having a largest weight in said composition,
weight ratio: the value of the material in the weight ratio between the EL material S and the EL material N, and
saturated solubility: the saturated solubility (wt%) of the material at 20°C and 1 atm for the solvent contained in said composition,
provided that each of the EL material N and the EL material S has a saturated solubility of 1 wt% or more for

toluene at 20˚C and 1 atm).

2. The composition for an organic electroluminescence element as claimed in claim 1, wherein said fluorescence-emitting material is a compound having a molecular weight of 10,000 or less.

3. The composition for an organic electroluminescence element as claimed in claim 1 or 2, wherein said EL material N is a charge transport material and said EL material S is a fluorescence-emitting material.

4. A composition for an organic electroluminescence element, comprising: two or more kinds of organic electroluminescence element materials; and a solvent, wherein
the boiling point of said solvent is 150˚C or more,
at least one of said organic electroluminescence element materials is a phosphorescence-emitting material, and the composition satisfies the following formula (2):

[Math. 2]

$$\frac{(\text{Saturated solubility of EL material S})}{(\text{Weight ratio of EL material S})} \times \frac{(\text{Weight ratio of EL material N})}{(\text{Saturated solubility of EL material N})} \geq 2.0 \quad \ldots (2)$$

(wherein:

EL material S: an organic electroluminescence element material having a smallest weight in said composition,
EL material N: an organic electroluminescence element material having a largest weight in said composition,
weight ratio: the value of the material in the weight ratio between the EL material S and the EL material N, and
saturated solubility: the saturated solubility (wt%) of the material at 20˚C and 1 atm for the solvent contained in said composition).

5. The composition for an organic electroluminescence element as claimed in claim 4, wherein said phosphorescence-emitting material is a compound having a molecular weight of 10,000 or less.

6. The composition for an organic electroluminescence element as claimed in claim 4 or 5, wherein said EL material N is a charge transport material and said EL material S is a phosphorescence-emitting material.

7. A composition for an organic electroluminescence element, comprising: two or more kinds of organic electroluminescence element materials; and a solvent, wherein
at least one of said organic electroluminescence element materials is a luminescent material and the composition satisfies the following formula (3) for cyclohexylbenzene:

[Math. 3]

$$\frac{(\text{Saturated solubility of EL material S})}{(\text{Weight ratio of EL material S})} \times \frac{(\text{Weight ratio of EL material N})}{(\text{Saturated solubility of EL material N})} \geq 2.0 \quad \ldots (3)$$

(wherein:

EL material S: an organic electroluminescence element material having a smallest weight in said composition,
EL material N: an organic electroluminescence element material having a largest weight in said composition,
weight ratio: the value of the material in the weight ratio between the EL material S and the EL material N, and
saturated solubility: the saturated solubility (wt%) of the material at 20˚C and 1 atm for cyclohexylbenzene).

**8.** An organic thin film formed using the composition for an organic electroluminescence element claimed in any one of claims 1 to 7.

**9.** An organic electroluminescence element comprising a luminescent layer between an anode and a cathode, wherein said luminescent layer is a layer formed using the composition for an organic electroluminescence element as claimed in any one of claims 1 to 7.

**10.** The organic electroluminescence element as claimed in claim 9, which comprises a hole transport layer adjacent to said luminescent layer, wherein said hole transport layer is a layer formed by a wet film-forming method.

**11.** The organic electroluminescence element as claimed in claim 10, wherein said hole transport layer is a layer formed by crosslinking a crosslinkable compound

**12.** The organic electroluminescence element as claimed in any one of claims 9 to 11, which comprises a hole injection layer between said anode and said luminescent layer, wherein said hole injection layer is a layer containing a hole transporting compound and an electron accepting compound and being formed by a wet film-forming method.

**13.** An organic EL display comprising the organic electroluminescence element as claimed in any one of claims 9 to 12.

**14.** An organic EL lighting comprising the organic electroluminescence element as claimed in any one of claims 9 to 12.

[ FIG. 1 ]

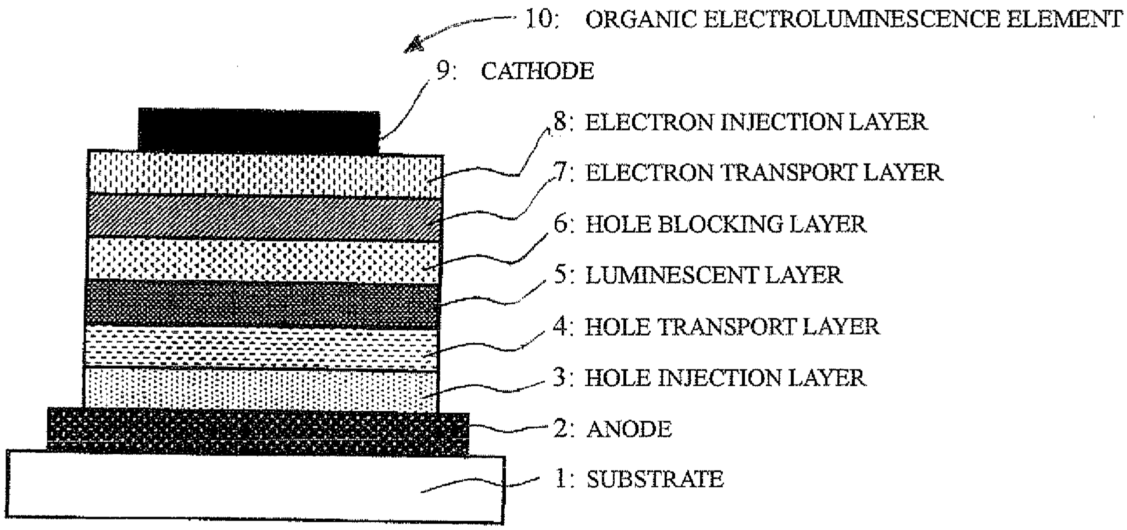
10: ORGANIC ELECTROLUMINESCENCE ELEMENT
9: CATHODE
8: ELECTRON INJECTION LAYER
7: ELECTRON TRANSPORT LAYER
6: HOLE BLOCKING LAYER
5: LUMINESCENT LAYER
4: HOLE TRANSPORT LAYER
3: HOLE INJECTION LAYER
2: ANODE
1: SUBSTRATE

## INTERNATIONAL SEARCH REPORT

International application No.
PCT/JP2009/063588

A. CLASSIFICATION OF SUBJECT MATTER
H01L51/50(2006.01)i, C09K11/06(2006.01)i, H05B33/10(2006.01)i

According to International Patent Classification (IPC) or to both national classification and IPC

B. FIELDS SEARCHED

Minimum documentation searched (classification system followed by classification symbols)
H01L51/50, C09K11/06, H05B33/10

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2008-124156 A (Idemitsu Kosan Co., Ltd.), 29 May 2008 (29.05.2008), claims 1, 8; paragraphs [0001] to [0013], [0068], [0071] to [0091] & US 2006/0190980 A1 & WO 2008/056722 A1 | 1-3,7-11,13, 14<br>4-6,12 |
| Y | JP 2008-13700 A (Canon Inc.), 24 January 2008 (24.01.2008), claims 1 to 3; paragraphs [0003], [0004], [0020] & US 2008/0009627 A1 | 4-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 October, 2009 (13.10.09) | 02 November, 2009 (02.11.09) |
| Name and mailing address of the ISA/<br>Japanese Patent Office<br>Facsimile No. | Authorized officer<br><br>Telephone No. |

Form PCT/ISA/210 (second sheet) (April 2007)

**INTERNATIONAL SEARCH REPORT**

International application No.
PCT/JP2009/063588

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2007-520858 A (Cambridge Display Technology Ltd.), 26 July 2007 (26.07.2007), paragraph [0096] & US 2009/0174311 A & GB 329364 D & EP 1695395 A & WO 2005/059951 A2 | 4-6 |
| Y | JP 2006-190759 A (Idemitsu Kosan Co., Ltd.), 20 July 2006 (20.07.2006), claims 1, 2; paragraph [0042] & US 2008/0124570 A1 & EP 1835006 A1 & WO 2006/073072 A1 & KR 10-2007-0091318 A & CN 101094904 A | 4-6 |
| Y | JP 2007-302624 A (Mitsubishi Chemical Corp.), 22 November 2007 (22.11.2007), paragraphs [0136] to [0139], [0221], [0226] (Family: none) | 4-6,12 |
| Y | JP 2008-31068 A (Mitsubishi Chemical Corp.), 14 February 2008 (14.02.2008), paragraphs [0079] to [0082], [0250], [0256] (Family: none) | 4-6,12 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004224766 A
- JP 5234681 A
- WO 2005089024 A
- JP 11251067 A
- JP 2003031365 A
- JP 7053953 A
- JP 11242996 A
- JP 7041759 A
- JP 10079297 A
- WO 2005022962 A
- JP 59194393 A
- US 5645948 A
- JP 6207169 A
- JP 5331459 A
- JP 10270171 A
- JP 2002100478 A
- JP 2002100482 A
- WO 2004084260 A
- JP 10074586 A
- JP 2008198250 A


### Non-patent literature cited in the description


- *Journal of Luminescence,* 1997, vol. 72-74, 985
- *Chemical Communications,* 1996, 2175
- *Synthetic Metals,* 1997, vol. 91 (209
- *Appl. Phys. Lett.,* 1992, vol. 60, 2711
- *J. Lumin.,* 1997, vol. 72-74, 985
- *Chem. Commun.,* 1996, 2175
- *Synth. Metals,* 1997, vol. 91, 209
- *Polym. Adv. Tech.,* 1996, vol. 7, 33
- *Applied Physics Letters,* 1997, vol. 70, 152
- *IEEE Transactions on Electron Devices,* 1997, vol. 44, 1245
- *SID 04 Digest,* 154
- **Seishi Tokito ; Chihaya Adachi ; Hideyuki Murata.** Yuki EL Display. Ohm-Sha, 20 August 2004